# EUROPEAN PATENT SPECIFICATION

(11) **EP 4 618 715 B1**
(45) Date of publication and mention of the grant of the patent: **09.09.2026**
(21) Application number: 24206391.5
(22) Date of filing: 14.10.2024
(51) Int. Cl.: H10D 30/01, H10D 62/50, H10D 62/60, H10D 30/47, H10D 62/17, H10D 62/85

(54) **SEMICONDUCTOR DEVICE**
HALBLEITERANORDNUNG
DISPOSITIF SEMI-CONDUCTEUR

(30) Priority: 11.03.2024 KR 20240033847
(43) Date of publication of application: 17.09.2025
(73) Proprietor: SAMSUNG ELECTRONICS CO., LTD., Yeongtong-gu Suwon-si, Gyeonggi-do 16677 (KR)
(72) Inventor: KIM, Joonyong, 16677 Suwon-si, Gyeonggi-do (KR); HWANG, In Jun, 16677 Suwon-si, Gyeonggi-do (KR); PARK, Junhyuk, 16677 Suwon-si, Gyeonggi-do (KR); LEE, Jung-Wook, 16677 Suwon-si, Gyeonggi-do (KR)
(74) Representative: Kuhnen & Wacker Patent- und Rechtsanwaltsbüro PartG mbB

(56) References cited:
- EP-A1- 4 287 265
- US-A1- 2007 249 119
- US-A1- 2019 189 792
- US-A1- 2021 399 120

## Description

### BACKGROUND

Power semiconductor devices are becoming increasingly important in various fields such as the transportation field, e.g., electric vehicles, trains, and electric trams, renewable energy systems, e.g., solar power generation and wind power generation, and mobile devices. Power semiconductor devices are semiconductor devices configured to handle high voltage or high current and perform functions, e.g., power conversion, and control in large power systems and high-power electronic devices. Power semiconductor devices have the ability and durability to handle high power, allowing them to handle large amounts of current and withstand high voltages. For example, power semiconductor devices can handle voltages of hundreds to thousands of volts and currents of tens to thousands of amperes. Power semiconductor devices can improve the efficiency of electrical energy by minimizing power losses. Further, power semiconductor devices can be stably driven in environments such as high temperatures.

These power semiconductor devices can be categorized by their materials, and for example, there are SiC power semiconductor devices and GaN power semiconductor devices. Instead of conventional silicon (Si) wafers, SiC or GaN may be used to manufacture power semiconductor devices, whereby it is possible to compensate for the disadvantages of silicon having unstable characteristics at high temperatures. SiC power semiconductor devices are resistant to high temperatures and have low power loss, making them suitable for electric vehicles, renewable energy systems, and the like. GaN power semiconductor devices require high costs, but are efficient in terms of speed, making them suitable for fast charging of mobile devices and the like.

EP 4 287 265 A1 describes a GaN-based high electron mobility transistor (HEMT) structure and manufacturing method aimed at improving p-type doping activation (particularly magnesium) by using lateral oxygen-implanted zones to trap hydrogen and prevent the formation of inactive Mg-H complexes.

US 2021/399120 A1 describes a high electron mobility transistor (HEMT) and its manufacturing method, aimed at eliminating threshold voltage inconsistencies (hump effects) by modifying the barrier layer structure with fluorine ions under the edges of the gate electrode.

US 2019/189792 A1 describes an InAlGaN high electron mobility transistor (HEMT) design that reduces ohmic contact resistance by separating the ohmic electrodes from a surface cap layer within an active area defined by Argon implantation.

US 2007/249119 A1 describes describes a nitride semiconductor device with a heterojunction field effect transistor (HFET) structure designed to achieve a normally-off operation with low on-resistance by integrating a p-type region and gate insulating layer under the gate electrode.

### SUMMARY

The invention is set out in the appended set of claims.

The high-electron mobility transistor as claimed can improve electrical characteristics and reliability. The invention is defined by the channel layer and barrier layer including a III-V material with the channel layer comprising active impurity regions that include at least one element from the list of Be, Ca, Sr, Ba, Li, Na, Mn, Fe, Co, Cu, Zn, Cd, or Mg as well as the active impurity regions being spaced apart from each other and overlapping with end portions of the gate electrode in a plan view. Alternatively, in the plan view, the end portions of the gate electrode are positioned together with edges of the active impurity regions on same lines. Some of these features may be referred to as optional in some parts of the description however, they are in fact, non-optional and always fall under the scope of the invention.

### BRIEF DESCRIPTION OF THE DRAWINGS

FIG. 1 is a plan view illustrating an example of a semiconductor device.
FIG. 2 is a cross-sectional view taken along line II-II' of FIG. 1.
FIG. 3 is a cross-sectional view taken along line III-III' of FIG. 1.
FIG. 4 is a plan view illustrating an example of a semiconductor device.
FIG. 5 is a cross-sectional view taken along line V-V' of FIG. 4.
FIG. 6 is a plan view illustrating an example of a semiconductor device.
FIG. 7 is a cross-sectional view taken along line VII-VII' of FIG. 6.
FIG. 8 is a plan view illustrating an example of a semiconductor device.
FIG. 9 is a cross-sectional view taken along line IX-IX' of FIG. 8.
FIG. 10 is a plan view illustrating an example of a semiconductor device.
FIG. 11 is a cross-sectional view taken along line XI-XI' of FIG. 10.
FIGS. 12 and 13 are cross-sectional views illustrating an example of a semiconductor device.
FIG. 14 is a plan view illustrating an example of a semiconductor device.
FIG. 15 is a cross-sectional view taken along line XV-XV' of FIG. 14.
FIG. 16 is a plan view illustrating an example of a semiconductor device.
FIGS. 17 to 22 are cross-sectional views illustrating examples of methods of manufacturing semiconductor devices.
FIGS. 23 and 24 are cross-sectional views illustrating examples of methods of manufacturing semiconductor devices.

### DETAILED DESCRIPTION

The drawings and description are to be regarded as illustrative in nature and not restrictive. Like reference numerals designate like elements throughout the specification.

In addition, the size and thickness of each configuration shown in the drawings are arbitrarily shown for understanding and ease of description, but the implementations are not limited thereto. In the drawings, the thickness of layers, films, panels, regions, etc., are exaggerated for clarity. Further, in the drawings, for understanding and ease of description, the thicknesses of some layers and areas are exaggerated.

Further, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity.

In addition, in the entire specification, unless explicitly described to the contrary, the word "comprise", and variations such as "comprises" or "comprising", will be understood to imply the inclusion of stated elements but not the exclusion of any other elements.

Further, in the entire specification, when it is referred to as "on a plane", it means when a target part is viewed from above, and when it is referred to as "on a cross-section", it means when the cross-section obtained by cutting a target part vertically is viewed from the side.

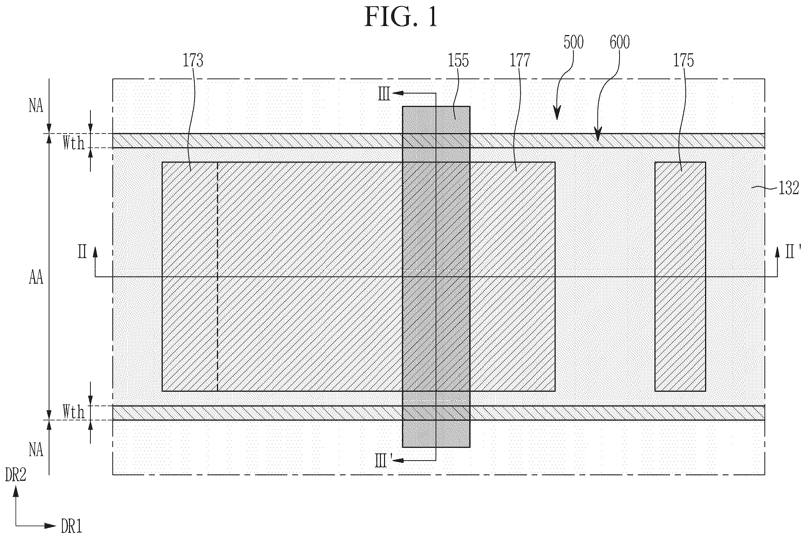

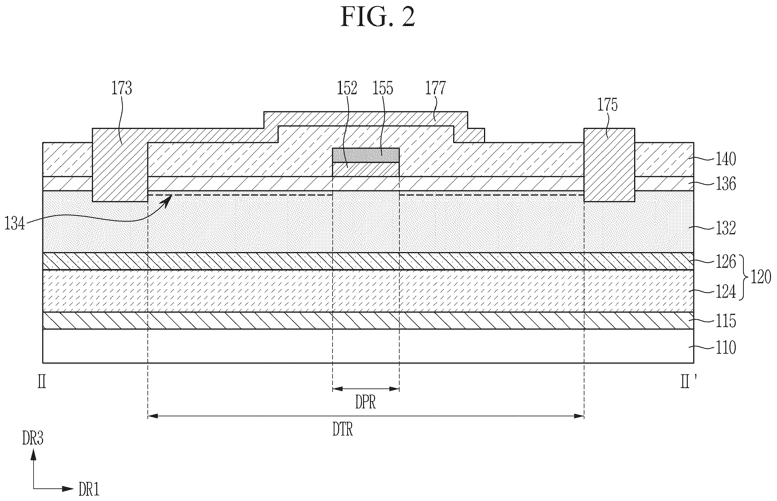

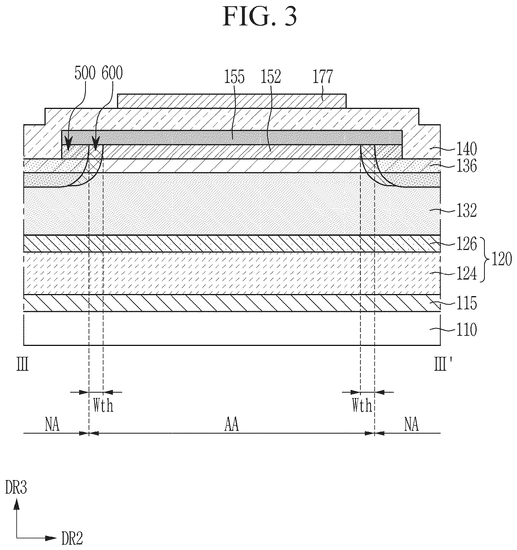

FIG. 1 is a plan view illustrating an example of a semiconductor device, FIG. 2 is a cross-sectional view taken along line II-II' of FIG. 1, and FIG. 3 is a cross-sectional view taken along line III-III' of FIG. 1.

As shown in FIGS. 1 to 3, a semiconductor device includes a channel layer 132, a barrier layer 136 that is positioned on the channel layer 132, a gate electrode 155 that is positioned on the barrier layer 136, a source electrode 173 and a drain electrode 175 that are positioned on both sides of the gate electrode 155 and are connected to the channel layer 132, and active doping regions 600 that are positioned in the channel layer 132.

The channel layer 132 may be a layer that forms a channel between the source electrode 173 and the drain electrode 175, and in the channel layer 132, a 2-dimensional electron gas (2DEG) 134 may be positioned. The 2-dimensional electron gas 134 adheres to a charge transfer model, e.g., as used in solid-state physics, and is a group of electrons that are tightly confined in two dimensions (for example, in directions on an x-y plane) such that the electrons are free to migrate in the two dimensions but cannot migrate in the other dimension (for example, in a z direction). In other words, the 2-dimensional electron gas 134 may exist in a form like a two-dimensional sheet in a three-dimensional space. Such 2-dimensional electron gases mainly appear in semiconductor heterojunction structures. In the semiconductor device of FIG. 1, the 2-dimensional electron gas 134 may occur at the interface between the channel layer 132 and the barrier layer 136. For example, the 2-dimensional electron gas 134 may occur at a portion in the channel layer 132 closest to the barrier layer 136.

The channel layer 132 may include III-V materials, for example, one or more materials selected from nitrides including at least one material of Al, Ga, In, and B. The channel layer 132 may consist of a single layer or multiple layers. The channel layer 132 may be formed of AlₓIn_{y}Ga_{1-x-y}N (wherein 0≤x≤1, 0≤y≤1, and x+y≤1). For example, the channel layer 132 may include at least one of AlN, GaN, InN, InGaN, AlGaN, AlInN, and AlInGaN. The channel layer 132 may be a layer doped with impurities, or may be a layer undoped with impurities. The thickness of the channel layer 132 may be about hundreds of nm or less.

The channel layer 132 may be positioned on a substrate 110, and between the substrate 110 and the channel layer 132, a seed layer 115, a buffer layer 120, and the like may be positioned. The substrate 110, the seed layer 115, and the buffer layer 120 may be layers necessary to form the channel layer 132, and may be omitted in some cases. For example, when a substrate made of GaN is used as the channel layer 132, at least one of the substrate 110, the seed layer 115, and the buffer layer 120 may be omitted. In consideration of the relatively high prices of substrates made of GaN, a substrate 110 made of Si may be used to grow a channel layer 132 including GaN. In this case, since the lattice structure of Si and the lattice structure of GaN are different, growing the channel layer 132 directly on the substrate 110 can be difficult. Therefore, a seed layer 115 and a buffer layer 120 may be first grown on the substrate 110, and then the channel layer 132 may be grown on the buffer layer 120. Also, at least one of the substrate 110, the seed layer 115, and the buffer layer 120 may be removed from the final structure of the semiconductor device after being used in the manufacturing process.

The substrate 110 may include a semiconductor material. For example, the substrate 110 may include sapphire, Si, SiC, AlN, GaN, or a combination thereof. The substrate 110 may be a silicon-on-insulator (SOI) substrate. However, the material of the substrate 110 is not limited thereto, and generally used substrates may be applied. In some cases, the substrate 110 may include an insulating material. For example, several layers including the channel layer 132 may be formed on a semiconductor substrate first, and then the semiconductor substrate may be removed and replaced with an insulating substrate.

The seed layer 115 may be positioned on the substrate 110. The seed layer 115 may be positioned directly on the substrate 110. However, the present disclosure is not limited thereto, and between the substrate 110 and the seed layer 115, other predetermined layers may be further positioned. The seed layer 115 is a layer to serve as a seed for growing the buffer layer 120 and may have a crystal lattice structure to be a seed for the buffer layer 120. For example, the seed layer 115 may include AlN, but is not limited thereto.

The buffer layer 120 may be positioned on the seed layer 115. The buffer layer 120 may be positioned directly on the seed layer 115. However, the present disclosure is not limited thereto, and between the seed layer 115 and the buffer layer 120, other predetermined layers may be further positioned. The buffer layer 120 may be positioned between the seed layer 115 and the channel layer 132. The buffer layer 120 may include III-V materials, for example, one or more materials selected from nitrides including at least one material of Al, Ga, In, and B. The buffer layer 120 may be formed of AlₓIn_{y}Ga_{1-x-y}N (wherein 0≤x≤1, 0≤y≤1, and x+y≤1). For example, the buffer layer 120 may include at least one of AlN, GaN, InN, InGaN, AlGaN, AlInN, and AlInGaN. The buffer layer 120 may consist of a single layer or multiple layers. The buffer layer 120 may include a superlattice layer 124, and a high-resistivity layer 126 that is positioned on the superlattice layer 124. The high-resistivity layer 126 may be positioned on the superlattice layer 124. At least one of the superlattice layer 124 and the high-resistivity layer 126 may be omitted. In some cases, the buffer layer 120 may further include other additional layers as well as the superlattice layer 124 and the high-resistivity layer 126.

The superlattice layer 124 may be positioned on the seed layer 115. The superlattice layer 124 may be positioned directly on the seed layer 115. However, the present disclosure is not limited thereto, and other predetermined layers may be further positioned between the seed layer 115 and the superlattice layer 124. The superlattice layer 124 may be positioned between the substrate 110 and the channel layer 132. The superlattice layer 124 is a layer for migrating differences in lattice constant and thermal expansion coefficient between the substrate 110 and the channel layer 132, thereby relieving tensile stress and compressive stress that is generated between the substrate 110 and the channel layer 132 and relieving stress between all layers formed by growth in the final structure of the semiconductor device. The superlattice layer 124 may include III-V materials, for example, one or more materials selected from nitrides including at least one material of Al, Ga, In, and B. The superlattice layer 124 may be formed of AlₓIn_{y}Ga_{1-x-y}N (wherein 0≤x≤1, 0≤y≤1, and x+y≤1). For example, the superlattice layer 124 may include at least one of AlN, GaN, InN, InGaN, AlGaN, AlInN, and AlInGaN. The superlattice layer 124 may consist of a single layer or multiple layers. For example, the superlattice layer 124 may have a structure in which layers consisting of AlGaN and layers consisting of GaN are alternately stacked. For example, AlGaN, GaN, AlGaN, GaN, AlGaN, and GaN are sequentially stacked on the seed layer 115 so as to form the superlattice layer 124. The numbers of AlGaN layers and GaN layers which constitute the superlattice layer 124 may be variously changed, and the materials that constitute the superlattice layer 124 may be variously changed.

The high-resistivity layer 126 may be positioned on the superlattice layer 124. The high-resistivity layer 126 may be positioned directly on the superlattice layer 124. However, the present disclosure is not limited thereto, and other predetermined layers may be further positioned between the superlattice layer 124 and the high-resistivity layer 126. The high-resistivity layer 126 may be positioned between the superlattice layer 124 and the channel layer 132. The high-resistivity layer 126 is a layer for preventing leakage current from flowing through the channel layer 132, thereby preventing the semiconductor device from being deteriorated. The high-resistivity layer 126 may include a material having low conductivity such that the substrate 110, and the channel layer 132 can be electrically insulated from each other. The high-resistivity layer 126 may include III-V materials, for example, one or more materials selected from nitrides including at least one material of Al, Ga, In, and B. The high-resistivity layer 126 may be formed of AlₓIn_{y}Ga_{1-x-y}N (wherein 0≤x≤1, 0≤y≤1, and x+y≤1). For example, the high-resistivity layer 126 may include at least one of AlN, GaN, InN, InGaN, AlGaN, AlInN, and AlInGaN. The high-resistivity layer 126 may consist of a single layer or multiple layers. The high-resistivity layer 126 may be a layer undoped with impurities. However, the high-resistivity layer 126 is not limited thereto, and may include an impurity. For example, the high-resistivity layer 126 may be doped with an impurity consisting of carbon (C), magnesium (Mg), iron (Fe), or a combination thereof. The impurity doping concentration of the high-resistivity layer 126 may be different from the impurity doping concentration of the channel layer 132.

The barrier layer 136 may be positioned on the channel layer 132. The barrier layer 136 may be positioned directly on the channel layer 132. However, the present disclosure is not limited thereto, and other predetermined layers may be further positioned between the channel layer 132 and the barrier layer 136. A region of the channel layer 132 overlapping the barrier layer 136 may become a drift region DTR. The drift region DTR may be positioned between the source electrode 173 and the drain electrode 175. When a potential difference occurs between the source electrode 173 and the drain electrode 175, carriers may migrate in the drift region DTR. The semiconductor device may be turned on and off depending on whether a voltage is applied to the gate electrode 155 and the magnitude of the voltage that is applied to the gate electrode 155. When a voltage equal to or higher than a threshold voltage is applied to the gate electrode 155 and the semiconductor device is in the ON state, a channel may be generated in a depletion region DPR. Therefore, carriers may migrate in the depletion region DPR. When a voltage lower than the threshold voltage is applied to the gate electrode 155 or no voltage is applied, the channel path may be blocked in the depletion region DPR and carrier migration may not occur.

The barrier layer 136 may include III-V materials, for example, one or more materials selected from nitrides including at least one material of Al, Ga, In, and B. The barrier layer 136 may be formed of AlₓIn_{y}Ga_{1-x-y}N (wherein 0≤x≤1, 0≤y≤1, and x+y≤1). The barrier layer 136 may include at least one of GaN, InN, AlGaN, AlInN, InGaN, AlN, AlInGaN, and the like. The energy band gap of the barrier layer 136 may be adjusted by the composition ratio of at least one of Al and In.

The barrier layer 136 may include a semiconductor material having different characteristics from those of the channel layer 132. At least one of the polarization characteristics, energy band gap, and lattice constant of the barrier layer 136 may be different from that of the channel layer 132. For example, the barrier layer 136 may include a material having an energy band gap different from that of the channel layer 132. In this case, the barrier layer 136 may have an energy band gap higher than that of the channel layer 132 and may have electrical polarizability higher than that of the channel layer 132. By this barrier layer 136, the 2-dimensional electron gas 134 may be induced in the channel layer 132 having relatively low electrical polarizability. In this regard, the barrier layer 136 may be referred to as a channel supply layer or a 2-dimensional electron gas supply layer. The 2-dimensional electron gas 134 may be formed in a portion of the channel layer 132 positioned below the interface between the channel layer 132 and the barrier layer 136. The 2-dimensional electron gas 134 may have very high electron mobility.

The barrier layer 136 may consist of a single layer or multiple layers. When the barrier layer 136 consists of multiple layers, the materials of the individual layers constituting the multiple layers may have different energy band gaps. In this case, the multiple layers constituting the barrier layer 136 may be disposed such that a layer closer to the channel layer 132 has a higher energy band gap.

The gate electrode 155 may be positioned on the barrier layer 136. The gate electrode 155 may overlap a partial region of the barrier layer 136. The gate electrode 155 may overlap a portion of the drift region DTR of the channel layer 132. The gate electrode 155 may be positioned between the source electrode 173 and the drain electrode 175. The gate electrode 155 may be spaced apart from the source electrode 173 and the drain electrode 175 in a first direction DR1. The first direction DR1 may be a direction parallel with the upper surface of the substrate 110 or the upper surface of the channel layer 132. The gate electrode 155 may be positioned approximately at the center between the source electrode 173 and the drain electrode 175. In other words, the separation distance between the gate electrode 155 and the source electrode 173 in the first direction DR1 may be similar to the separation distance between the gate electrode 155 and the drain electrode 175 in the first direction DR1. However, the position of the gate electrode 155 is not limited thereto and may be variously changed. The gate electrode 155 may be positioned closer to the source electrode 173 than to the drain electrode 175. In other words, the separation distance between the gate electrode 155 and the source electrode 173 may be smaller than the separation distance between the gate electrode 155 and the drain electrode 175.

The gate electrode 155 may extend in a second direction DR2 different from the first direction DR1 on a plane. The second direction DR2 may be a direction parallel with the upper surface of the substrate 110 or the upper surface of the channel layer 132 and may be a direction intersecting the first direction DR1. For example, the second direction DR2 may be a direction perpendicular to the first direction DR1. The gate electrode 155 may have a rod shape extending along the second direction DR2.

The gate electrode 155 may include a conductive material. For example, the gate electrode 155 may include a metal, a metal alloy, a conductive metal nitride, a metal silicide, a doped semiconductor material, a conductive metal oxide, a conductive metal oxynitride, or the like. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate electrode 155 may consist of a single layer or multiple layers.

The semiconductor device may further include a gate semiconductor layer 152 that is positioned between the barrier layer 136 and the gate electrode 155. The gate semiconductor layer 152 may be positioned on the barrier layer 136.

On the gate semiconductor layer 152, the gate electrode 155 may be positioned. The gate electrode 155 may be in contact with the gate semiconductor layer 152. The lower surface of the gate electrode 155 may be in contact with the gate semiconductor layer 152. However, the present disclosure is not limited thereto and other predetermined layers may be further positioned between the gate electrode 155 and the gate semiconductor layer 152. The gate electrode 155 may be brought into Schottky contact with the gate semiconductor layer 152. However, the present disclosure is not limited thereto and in some cases, the gate electrode 155 may be brought into ohmic contact with the gate semiconductor layer 152. The gate semiconductor layer 152 may overlap the gate electrode 155 in a third direction DR3. The third direction DR3 may be a direction perpendicular to the first direction DR1 and the second direction DR2. In other words, the third direction DR3 may be a direction perpendicular to the upper surface of the substrate 110 or the upper surface of the channel layer 132. The gate electrode 155 may be patterned using the same mask as that for the gate semiconductor layer 152. Accordingly, the gate electrode 155 may have substantially the same plane shape as that of the gate semiconductor layer 152. The gate electrode 155 may have substantially the same width as that of the gate semiconductor layer 152.

The gate semiconductor layer 152 may be positioned between the source electrode 173 and the drain electrode 175. The gate semiconductor layer 152 may be spaced apart from the source electrode 173 and the drain electrode 175. The gate semiconductor layer 152 may be positioned approximately at the center between the source electrode 173 and the drain electrode 175. In other words, the separation distance between the gate semiconductor layer 152 and the source electrode 173 in the first direction DR1 may be similar to the separation distance between the gate semiconductor layer 152 and the drain electrode 175 in the first direction DR1. However, the position of the gate semiconductor layer 152 is not limited thereto and may be variously changed. The gate semiconductor layer 152 may be positioned closer to the source electrode 173 than to the drain electrode 175. In other words, the separation distance between the gate semiconductor layer 152 and the source electrode 173 may be smaller than the separation distance between the gate semiconductor layer 152 and the drain electrode 175.

The gate semiconductor layer 152 may include III-V materials, for example, one or more materials selected from nitrides including at least one of Al, Ga, In, and B. The gate semiconductor layer 152 may be formed of AlₓIn_{y}Ga_{1-x-y}N (wherein 0≤x≤1, 0≤y≤1, and x+y≤1). For example, the gate semiconductor layer 152 may include at least one of AlN, GaN, InN, InGaN, AlGaN, AlInN, and AlInGaN. The gate semiconductor layer 152 may include a material having an energy band gap different from that of the barrier layer 136. For example, the gate semiconductor layer 152 may include GaN, and the barrier layer 136 may include AlGaN. The gate semiconductor layer 152 may be doped with a predetermined impurity. In this case, the impurity with which the gate semiconductor layer 152 is doped may be a p-type impurity capable of providing holes. For example, the gate semiconductor layer 152 may include GaN doped with a p-type impurity. In other words, the gate semiconductor layer 152 may consist of a p-GaN layer. However, the gate semiconductor layer 152 is not limited thereto and may be a p-AlGaN layer. For example, the impurity with which the gate semiconductor layer 152 is doped may be magnesium (Mg). The gate semiconductor layer 152 may consist of a single layer or multiple layers.

By the gate semiconductor layer 152, a depletion region DPR may be formed in the channel layer 132. The depletion region DPR may be positioned in the drift region DTR and may have a width smaller than that of the drift region DTR. As the gate semiconductor layer 152 having an energy band gap different from that of the barrier layer 136 is positioned on the barrier layer 136, the level of the energy band of a portion of the barrier layer 136 overlapping the gate semiconductor layer 152 may be raised. Accordingly, the depletion region DPR may be formed in the channel layer 132 overlapping the gate semiconductor layer 152. The depletion region DPR may be a region on the channel path of the channel layer 132 where the 2-dimensional electron gas 134 is not formed or that has an electron concentration lower than that of the other regions. In other words, the depletion region DPR may refer to a region in the drift region DTR where the flow of the 2-dimensional electron gas 134 is cut off. As the depletion region DPR is generated, no current may flow between the source electrode 173 and the drain electrode 175, and the channel path may be blocked. Accordingly, the semiconductor device may have a normally-off characteristic.

In other words, the semiconductor device may be a normally-off high electron mobility transistor (HEMT). In a normal state in which voltage is not applied to the gate electrode 155, the depletion region DPR may exist, and the semiconductor device may be off. When a voltage equal to or higher than a threshold voltage is applied to the gate electrode 155, the depletion region DPR may disappear, and the 2-dimensional electron gas 134 may continue in the drift region DTR, without being cut. In other words, the 2-dimensional electron gas 134 may be formed over the entire channel path between the source electrode 173 and the drain electrode 175, and the semiconductor device may be turned on. In summary, the semiconductor device may include semiconductor layers having different electrical polarization characteristics, and a semiconductor layer having relatively high polarizability may cause the 2-dimensional electron gas 134 in another semiconductor layer to form a heterojunction with the other semiconductor layer. This 2-dimensional electron gas 134 may be used as a channel between the source electrode 173 and the drain electrode 175, and the continuation or interruption of the flow of the 2-dimensional electron gas 134 may be controlled by a bias voltage that is applied to the gate electrode 155. In the gate-off state, the flow of the 2-dimensional electron gas 134 may be blocked, whereby no current flows between the source electrode 173 and the drain electrode 175. In the gate-on state, as the flow of the 2-dimensional electron gas 134 continues, current may flow between the source electrode 173 and the drain electrode 175.

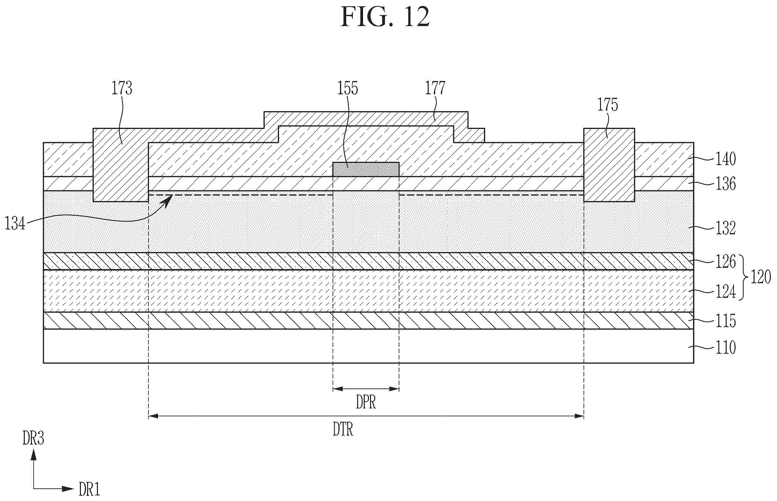

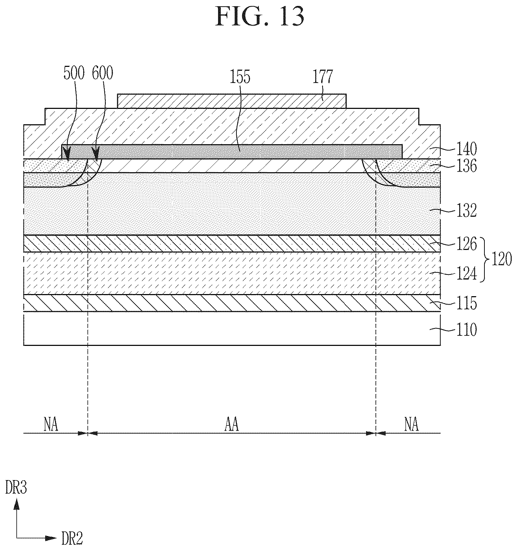

Although it has been described above that the semiconductor device is a normally-off high electron mobility transistor, the present disclosure is not limited thereto. For example, the semiconductor device may be a normally-on high electron mobility transistor, and this will be described below in a description of FIGS. 12 and 13.

The buffer layer 120, the superlattice layer 124, the high-resistivity layer 126, the channel layer 132, the barrier layer 136, and the gate semiconductor layer 152 described above may be sequentially stacked on the substrate 110. In the semiconductor device, at least one of the buffer layer 120, the superlattice layer 124, the high-resistivity layer 126, the channel layer 132, the barrier layer 136, and the gate semiconductor layer 152 may be omitted. The buffer layer 120, the superlattice layer 124, the high-resistivity layer 126, the channel layer 132, the barrier layer 136, and the gate semiconductor layer 152 may consist of semiconductor materials based on the same materials, and the material composition ratios of the individual layers may be different from one another in view of the roles of the individual layers, the performance required for the semiconductor device, and the like.

The semiconductor device may further include non-active doping regions 500. The channel layer 132 may include an active area AA and non-active areas NA. In the active area AA, the drift region DTR may be positioned, and the non-active areas NA may be positioned near the active area AA. The non-active doping regions 500 may be positioned in the non-active areas NA of the channel layer 132. The non-active doping regions 500 may include a non-active impurity. The non-active doping regions 500 may be regions doped with the non-active impurity. For example, the non-active impurity may include a material such as Ar, H, etc. The non-active doping regions 500 may be formed using an ion implantation process (IIP). In some cases, the non-active doping regions 500 may be omitted. Instead, the non-active areas NA of the channel layer 132 may be removed, and the portions from which the non-active areas NA have been removed may be filled with an insulating layer so as to perform the same role as that of the non-active doping regions 500. In this case, the non-active areas NA of the channel layer 132 may be entirely removed or may be removed only by a predetermined thickness.

The non-active doping regions 500 may be positioned in the non-active areas NA of the channel layer 132 and may not be positioned in the active area AA of the channel layer 132. The non-active doping regions 500 may be mostly positioned in the non-active areas NA of the channel layer 132 on a plane and may be positioned up to the boundaries between the non-active areas NA and the active area AA. The semiconductor device may include a plurality of high electron mobility transistors and other devices for driving them. In this case, in order to prevent an electrical effect between the plurality of high electron mobility transistors or between the high electron mobility transistors and the other devices, non-active areas NA may be provided. Accordingly, the non-active areas NA may be positioned near active areas AA where the high electron mobility transistors are positioned. For example, the non-active areas NA may be disposed on both sides of each of the active areas AA so as to be spaced apart from each other in the second direction DR2. Also, the non-active areas NA may extend along the first direction DR1. The non-active doping regions 500 positioned in the non-active areas NA may be disposed on both sides of each of the source electrode 173, the gate electrode 155, and the drain electrode 175 so as to be spaced apart from each other in the second direction DR2 and may extend along the first direction DR1.

The non-active areas NA may not overlap the source electrode 173 and the drain electrode 175 in the third direction DR3. The non-active doping regions 500 may not overlap the source electrode 173 and the drain electrode 175 in the third direction DR3. The non-active areas NA may overlap the gate semiconductor layer 152 in the third direction DR3. The non-active doping regions 500 may overlap the gate semiconductor layer 152 in the third direction DR3. The non-active areas NA may overlap the gate electrode 155 in the third direction DR3. The non-active doping regions 500 may overlap the gate electrode 155 in the third direction DR3. The length of the gate semiconductor layer 152 along the second direction DR2 may be longer than the length of the source electrode 173 along the second direction DR2 and may be longer than the length of the drain electrode 175 along the second direction DR2. The length of the gate electrode 155 along the second direction DR2 may be longer than the length of the source electrode 173 along the second direction DR2, and may be longer than the length of the drain electrode 175 along the second direction DR2. However, the overlapping relationship of the non-active areas NA or the non-active doping regions 500 with the other components may be variously changed.

The non-active doping regions 500 may be positioned in the barrier layer 136 and the gate semiconductor layer 152, as well as in the channel layer 132. When the depths of the non-active doping regions 500 are viewed in a cross section, the non-active doping regions 500 may be mostly distributed along the third direction DR3 from the upper surface to the lower surface of the gate semiconductor layer 152. Similarly, the non-active doping regions 500 may be mostly distributed along the third direction DR3 from the upper surface to the lower surface of the barrier layer 136. However, at the boundaries between the active area AA and the non-active areas NA, the non-active doping regions 500 may be distributed only up to a predetermined depth from the upper surface of the gate semiconductor layer 152 or the barrier layer 136. The non-active doping regions 500 may be distributed only up to a predetermined depth from the upper surface of the channel layer 132. In other words, the non-active doping regions 500 may not be distributed throughout the channel layer 132 from the upper surface to the lower surface. However, this is merely an example, and the depth and distribution form of the non-active doping regions 500 may be variously changed.

The active doping regions 600 may be positioned in the active area AA of the channel layer 132. The active doping regions 600 may be adjacent to the non-active areas NA of the channel layer 132. At least some portions of the active doping regions 600 may be further positioned in the non-active areas NA of the channel layer 132. However, the present disclosure is not limited thereto, and the active doping regions 600 may not be positioned in the non-active areas NA at all. The active doping regions 600 may include an active impurity. The active doping regions 600 may be regions doped with the active impurity. The active impurity is different from the non-active impurity and may be a material capable of increasing the threshold voltage of transistors. For example, the active impurity may include a material such as fluorine (F), beryllium (Be), calcium (Ca), strontium (Sr), barium (Ba), lithium (Li), sodium (Na), manganese (Mn), iron (Fe), cobalt (Co), copper (Cu), zinc (Zn), cadmium (Cd), oxygen (O), magnesium (Mg), etc. The active doping regions 600 may be formed using an ion implantation process. The active doping regions 600 may include one kind of impurity. Alternatively, the active doping regions 600 may include two or more kinds of impurities. For example, the active doping regions 600 may include only fluorine (F) or may include fluorine (F) and oxygen (O) together, or may include fluorine (F), oxygen (O), and magnesium (Mg) together. The non-active doping regions 500 may further include an active impurity as well as the non-active impurity. The non-active doping regions 500 are portions where the channel layer 132 is inactivated by the non-active impurity, and even though the non-active doping regions 500 may further include an active impurity, the channel layer 132 may not be activated. The active doping regions 600 may include only the active impurity and may include no non-active impurities.

The active doping regions 600 may be positioned at the edges of the active area AA so as to be adjacent to the non-active areas NA of the channel layer 132. The active doping regions 600 may be in contact with the non-active doping regions 500. The active doping regions 600 may be disposed adjacent to the non-active areas NA positioned on both sides of the active area AA, so as to be spaced apart from each other in the second direction DR2 and may extend along the first direction DR1. The active doping regions 600 may be positioned on both sides of the gate electrode 155. The active doping regions 600 may be further positioned on both sides of each of the source electrode 173 and the drain electrode 175. The active doping regions 600 may extend in the first direction DR1 along the boundaries between the active area AA and the non-active areas NA. However, the present disclosure is not limited thereto, and the active doping regions 600 may be positioned only at the portions adjacent to the gate electrode 155.

The active doping regions 600 may not overlap the source electrode 173 and the drain electrode 175 in the third direction DR3. The active doping regions 600 may overlap the gate semiconductor layer 152 in the third direction DR3. The active doping regions 600 may overlap the gate electrode 155 in the third direction DR3. However, the overlapping relationship of the active doping regions 600 with the other components may be variously changed.

The active doping regions 600 may be further positioned in the barrier layer 136 and the gate semiconductor layer 152 as well as in the channel layer 132. When the depths of the active doping regions 600 are viewed in a cross section, the active doping regions 600 may be mostly distributed along the third direction DR3 from the upper surface to the lower surface of the gate semiconductor layer 152. Similarly, the active doping regions 600 may be mostly distributed along the third direction DR3 from the upper surface to the lower surface of the barrier layer 136. However, at some regions, for example, at both edges of each active doping region 600, the active doping region 600 may be distributed only up to a predetermined depth from the upper surface of the gate semiconductor layer 152 or the barrier layer 136, or may be distributed only up to a predetermined height from the lower surface of the gate semiconductor layer 152 or the barrier layer 136. The active doping regions 600 may be distributed only up to a predetermined depth from the upper surface of the channel layer 132. In other words, the active doping regions 600 may not be distributed throughout the channel layer 132 from the upper surface to the lower surface. However, this is merely an example, and the depth and distribution form of the active doping regions 600 may be variously changed.

The boundaries between the non-active doping regions 500 and the active doping regions 600 may not have a straight line shape parallel with the third direction DR3 in a cross section. For example, the boundaries between the non-active doping regions 500 and the active doping regions 600 may become farther from the active area AA along the second direction DR2 as they go away from the gate electrode 155 along the third direction DR3.

The width Wth of each active doping region 600 in the second direction DR2 may be equal to or larger than 0.1 µm and equal to or smaller than 5 µm. In this case, the width Wth of each active doping region 600 in the second direction DR2 may refer to the width of a portion of the active doping region 600 in contact with the gate electrode 155.

Since the semiconductor device includes the active doping regions 600, doped with a material such as fluorine (F), oxygen (O), magnesium (Mg), or the like, in the active area AA such that the active doping regions are adjacent to the non-active areas NA of the channel layer 132, the presence of the active doping regions 600 can prevent leakage current from occurring in the portions of the channel layer 132 adjacent to both edges of the gate electrode 155. In other words, since the active doping regions 600 are formed at the edges of the active area AA in contact with the non-active areas NA of the channel layer 132, increasing the threshold voltage of the high electron mobility transistor constituting the semiconductor device is possible.

The semiconductor device may further include a protective layer 140 that is positioned on the barrier layer 136, the gate semiconductor layer 152, and the gate electrode 155. The protective layer 140 may cover the upper surface of the barrier layer 136 and may cover the side surfaces of the gate semiconductor layer 152 and may cover the upper surface and side surfaces of the gate electrode 155. The protective layer 140 may be in contact with the barrier layer 136, the gate semiconductor layer 152, and the gate electrode 155. The barrier layer 136, the gate semiconductor layer 152, the gate electrode 155, and the like may be protected and be separated from the other components by the protective layer 140. The protective layer 140 may include an insulating material. For example, the protective layer 140 may include an oxide such as SiO₂, Al₂O₃, etc. As another example, the protective layer 140 may include a nitride such as SiN, or an oxynitride such as SiON. The protective layer 140 may consist of a single layer or multiple layers.

The source electrode 173 and the drain electrode 175 may be positioned on the channel layer 132. The source electrode 173 and the drain electrode 175 may be spaced apart from each other, and the gate electrode 155 and the gate semiconductor layer 152 may be positioned between the source electrode 173 and the drain electrode 175. The gate electrode 155 and the gate semiconductor layer 152 are spaced apart from the source electrode 173 and the drain electrode 175. The source electrode 173 may be electrically connected to the channel layer 132 on one side of the gate electrode 155. The drain electrode 175 may be electrically connected to the channel layer 132 on the other side of the gate electrode 155. The source electrode 173 and the drain electrode 175 may be positioned on the outside of the drift region DTR of the channel layer 132. The interface between the source electrode 173 and the channel layer 132 may be one edge of the drift region DTR. Similarly, the interface between the drain electrode 175 and the channel layer 132 may be the other edge of the drift region DTR. However, the present disclosure is not limited thereto, and the source electrode 173 and the drain electrode 175 may not be positioned outside the drift region DTR of the channel layer 132. In this case, the channel layer 132 may not be recessed, and the source electrode 173 and the drain electrode 175 may be positioned on the upper surface of the channel layer 132. Alternatively, the barrier layer 136 may not be penetrated, and some portions of the barrier layer 136 may be recessed, whereby the source electrode 173 and the drain electrode 175 may be positioned on the upper surface of the barrier layer 136. The lower surfaces of the source electrode 173 and the drain electrode 175 may be in contact with the upper surface of the barrier layer 136. The portions of the barrier layer 136 that are in contact with the source electrode 173 and the drain electrode 175 might have been doped at a high concentration. In this case, carriers passing through the 2-dimensional electron gas 134 may be transferred to the source electrode 173 and the drain electrode 175 through the portions of the barrier layer 136 doped at the high concentration, e.g., the upper portions of the 2-dimensional electron gas 134. The source electrode 173 and the drain electrode 175 may not be in direct contact with the 2-dimensional electron gas 134 in a horizontal direction. The horizontal direction may refer to a direction parallel with the upper surface of the channel layer 132 or the barrier layer 136.

The source electrode 173 and the drain electrode 175 may be positioned on the protective layer 140. Trenches that are formed so as to pass through the protective layer 140, the barrier layer 136 and portions of the upper surface of the channel layer 132 may be positioned on both sides of the gate electrode 155 so as to be spaced apart from each other. The source electrode 173 and the drain electrode 175 may be positioned, respectively, in the trenches positioned on opposite sides of the gate electrode 155. The source electrode 173 and the drain electrode 175 may be formed so as to fill the trenches. In the trenches, the source electrode 173 and the drain electrode 175 may be in contact with the channel layer 132 and the barrier layer 136. The channel layer 132 may constitute the bottom surfaces and side walls of the trenches, and the barrier layer 136 may constitute the side walls of the trenches. Therefore, the source electrode 173 and the drain electrode 175 may be in contact with the upper surface and side surface of the channel layer 132. Further, the source electrode 173 and the drain electrode 175 may be in contact with the side surface of the barrier layer 136. In other words, the source electrode 173 and the drain electrode 175 may cover the side surfaces of the channel layer 132 and the barrier layer 136. The upper surfaces of the source electrode 173 and the drain electrode 175 may protrude from the upper surface of the protective layer 140. In some cases, at least one of the source electrode 173 and the drain electrode 175 may cover at least a portion of the upper surface of the protective layer 140.

The source electrode 173 and the drain electrode 175 may be spaced apart from each other in the first direction DR1. The source electrode 173 and the drain electrode 175 may extend in the second direction DR2 on a plane. The source electrode 173 and the drain electrode 175 may extend in a direction parallel with the gate electrode 155.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, a conductive metal oxynitride, or the like. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The source electrode 173 and the drain electrode 175 may consist of a single layer or multiple layers. The source electrode 173 and the drain electrode 175 may be in ohmic contact with the channel layer 132. The regions in the channel layer 132 that are in contact with the source electrode 173 and the drain electrode 175 may be doped at a relatively higher concentration as compared to the other region.

A field dispersion layer 177 may be positioned between the source electrode 173 and the drain electrode 175. The field dispersion layer 177 may overlap the gate electrode 155 in the third direction DR3. The gate electrode 155 may be covered by the field dispersion layer 177. The field dispersion layer 177 may be electrically connected to the source electrode 173. The field dispersion layer 177 may include the same material as that of the source electrode 173, and may be positioned together with the source electrode 173 in the same layer. The field dispersion layer 177 may be formed together with the source electrode 173 in the same process. In other words, the boundary between the field dispersion layer 177 and the source electrode 173 may not be clear, and the field dispersion layer 177 may be formed integrally with the source electrode 173. However, the field dispersion layer 177 is not limited thereto, and may be an individual constituent element separated from the source electrode 173. Also, the field dispersion layer 177 and the source electrode 173 may be positioned in different layers, respectively, and may be formed in different processes, respectively. In some cases, the field dispersion layer 177 may be electrically connected to the gate electrode 155. For example, an opening may be formed in the protective layer 140 so as to overlap the gate electrode 155, and the field dispersion layer 177 may be connected to the gate electrode 155 through the opening. In this case, the field dispersion layer 177 may not be connected to the source electrode 173.

The field dispersion layer 177 may serve to disperse an electric field concentrated around the gate electrode 155. When a high voltage is applied to the drain electrode 175 in the gate-off state, an electric field may be concentrated around the gate electrode 155. When the electric field is concentrated on the gate electrode 155, the leakage current may increase, and the breakdown voltage may decrease. The electric field that is concentrated around the gate electrode 155 may be dispersed by the field dispersion layer 177, whereby leakage current may be reduced and the breakdown voltage may be increased.

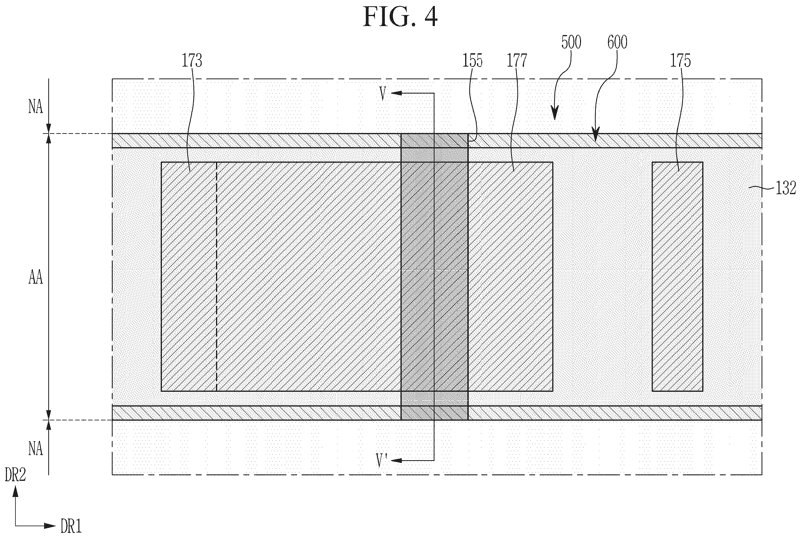

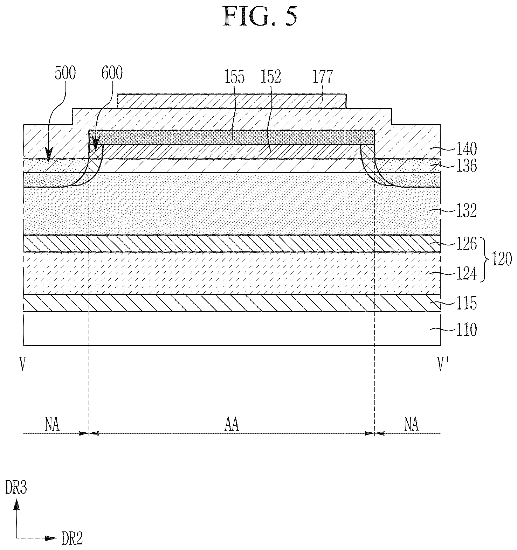

FIG. 4 is a plan view illustrating an example of a semiconductor device, and FIG. 5 is a cross-sectional view taken along line V-V' of FIG. 4.

Description of FIGS. 1, 2, 3 relevant to FIGS. 4 and 5 will be omitted for brevity. Constituent elements identical to those of the FIGS. 1, 2, and 3 are denoted by the same reference symbols. Compared to the FIGS. 1, 2, and 3, in the semiconductor device of FIGS. 4 and 5, a gate semiconductor layer does not overlap non-active doping regions.

As shown in FIGS. 4 and 5, a semiconductor device includes a channel layer 132, a barrier layer 136 that is positioned on the channel layer 132, a gate electrode 155 that is positioned on the barrier layer 136, a source electrode 173 and a drain electrode 175 that are positioned on both sides of the gate electrode 155 and are connected to the channel layer 132, and active doping regions 600 that are positioned in the channel layer 132. In the channel layer 132, non-active doping regions 500 may be further positioned. The semiconductor device may further include a gate semiconductor layer 152 that is positioned between the barrier layer 136 and the gate electrode 155.

In FIGS. 1, 2, and 3, the edges of the gate semiconductor layer 152 may overlap the non-active doping regions 500 in the third direction DR3, and in the semiconductor of FIGS. 4 and 5, the gate semiconductor layer 152 do not overlap the non-active doping regions 500 in the third direction DR3. Both end portions of the gate semiconductor layer 152 may be positioned together with the boundaries between the active doping regions 600 and the non-active doping regions 500 on the same lines. The gate semiconductor layer 152 may overlap the active doping regions 600 in the third direction DR3 and may not overlap the non-active doping regions 500 in the third direction DR3. The active doping regions 600 may be further positioned in the barrier layer 136 and the gate semiconductor layer 152. The non-active doping regions 500 may be further positioned in the barrier layer 136. The non-active doping regions 500 may not be positioned in the gate semiconductor layer 152.

Both end portions of the gate electrode 155 may be positioned together with the boundaries between the active doping regions 600 and the non-active doping regions 500 on the same lines. The gate electrode 155 may overlap the active doping regions 600 in the third direction DR3 and may not overlap the non-active doping regions 500 in the third direction DR3.

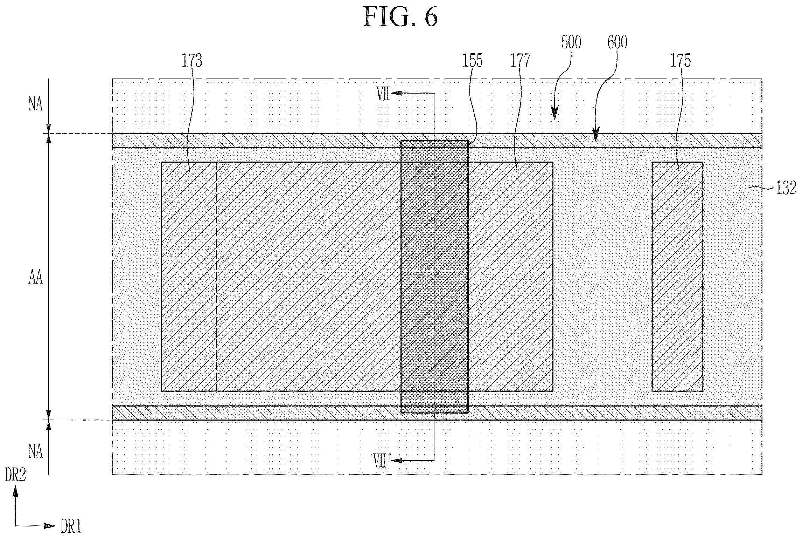

The positions of the end portions of the gate semiconductor layer 152 and the gate electrode 155 are not limited thereto, and may be variously changed, and hereinafter, some examples will be described with reference to FIGS. 6 to 9.

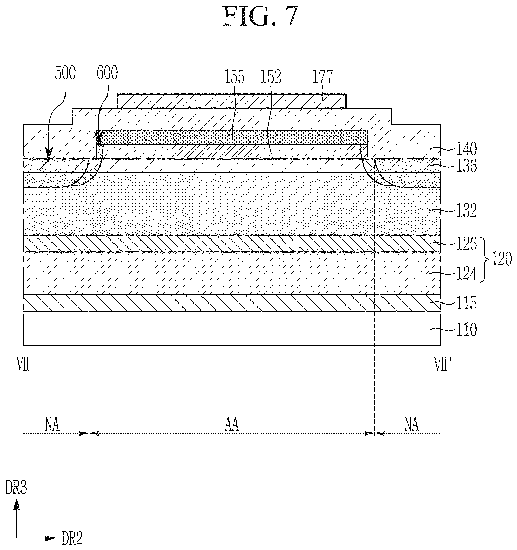

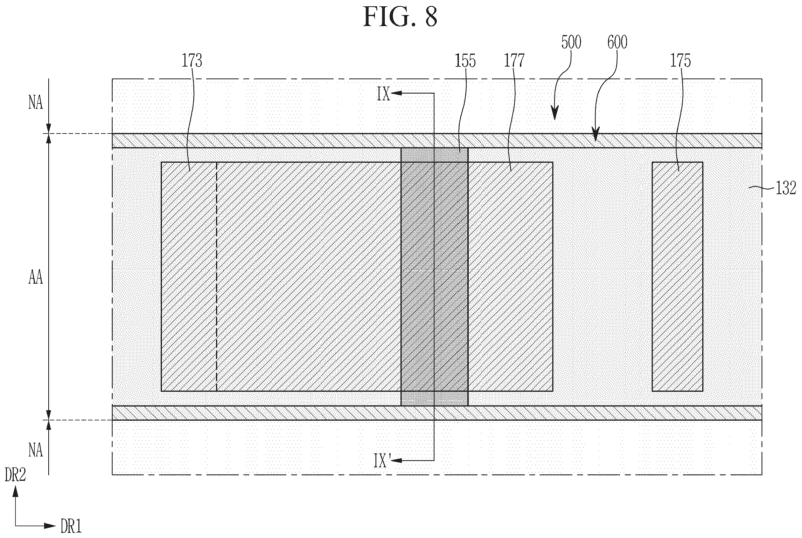

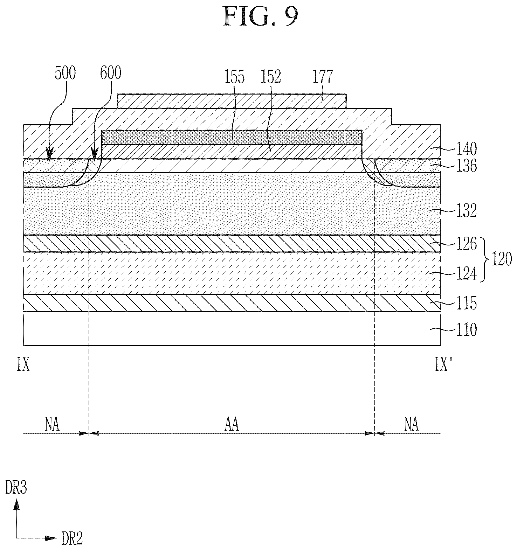

FIG. 6 is a plan view illustrating an example of a semiconductor device, and FIG. 7 is a cross-sectional view taken along line VII-VII' of FIG. 6. FIG. 8 is a plan view illustrating an example of a semiconductor device, and FIG. 9 is a cross-sectional view taken along line IX-IX' of FIG. 8.

As shown in FIGS. 6 and 7, both end portions of the gate semiconductor layer 152 may overlap the active doping regions 600 in the third direction DR3. For example, both end portions of the gate semiconductor layer 152 may overlap approximately the centers of the active doping regions 600 in the third direction DR3. Both end portions of the gate electrode 155 may overlap the active doping regions 600 in the third direction DR3. For example, both end portions of the gate electrode 155 may overlap approximately the centers of the active doping regions 600 in the third direction DR3.

As shown in FIGS. 8 and 9, both end portions of the gate semiconductor layer 152 may be positioned together with the edges of the active doping regions 600 on the same lines. The active doping regions 600 may include first edges adjacent to the non-active doping regions 500 and second edges adjacent to the gate semiconductor layer 152. Both end portions of the gate semiconductor layer 152 may be positioned together with the second edges of the active doping regions 600 on the same lines. The gate semiconductor layer 152 may not overlap the active doping regions 600 in the third direction DR3. The active doping regions 600 may not be positioned in the gate semiconductor layer 152. Both end portions of the gate electrode 155 may be positioned together with the second edges of the active doping regions 600 on the same lines. The gate electrode 155 may not overlap the active doping regions 600 in the third direction DR3.

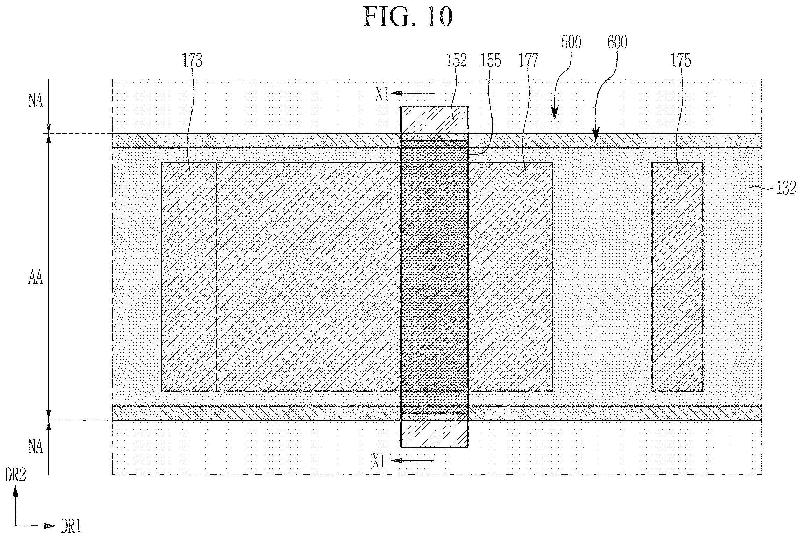

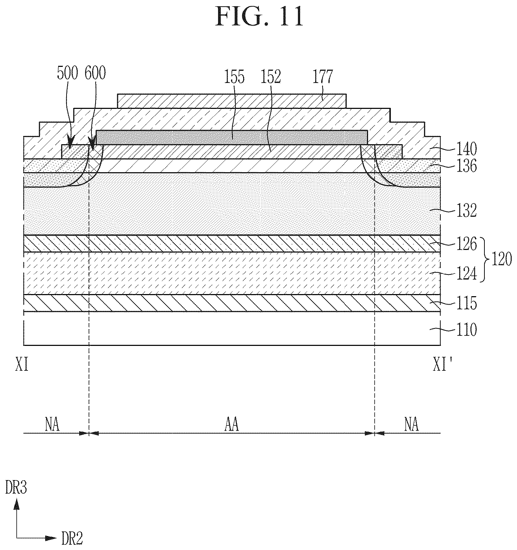

FIG. 10 is a plan view illustrating an example of a semiconductor device, and FIG. 11 is a cross-sectional view taken along line XI-XI' of FIG. 10.

Description of FIGS. 1, 2, 3 relevant to FIGS. 10 and 11 will be omitted for brevity. The same reference symbols are used for the elements identical to those described above. Compared the FIGS. 1-9, for the semiconductor device of FIGS. 10 and 11, a gate electrode 155 and a gate semiconductor layer 152 are different in size and shape.

As shown in FIGS. 10 and 11, the planar shape of the gate electrode 155 may be different from the planar shape of the gate semiconductor layer 152. In the semiconductor device of FIGS. 4, 5, and 6, the upper surface of the gate semiconductor layer 152 may be entirely covered by the gate electrode 155, and in the semiconductor device of FIGS. 10 and 11, a portion of the upper surface of the gate semiconductor layer 152 may be covered by the gate electrode 155, and the other portions may not be covered by the gate electrode 155. A portion of the upper surface of the gate semiconductor layer 152 may be in contact with the gate electrode 155, and the other portions of the upper surface of the gate semiconductor layer 152 may be in contact with the protective layer 140. The gate electrode 155 may be patterned using a mask different from that for the gate semiconductor layer 152.

The length of the gate electrode 155 in the second direction DR2 may be different from the length of the gate semiconductor layer 152 in the second direction DR2. The length of the gate electrode 155 in the second direction DR2 may be shorter than the length of the gate semiconductor layer 152 in the second direction DR2. The length of the gate electrode 155 in the first direction DR1 may be substantially the same as the length of the gate semiconductor layer 152 in the first direction DR1.

The gate semiconductor layer 152 may overlap the active doping regions 600 and the non-active doping regions 500 in the third direction DR3. The active doping regions 600 and the non-active doping regions 500 may be further positioned in the gate semiconductor layer 152. The gate electrode 155 may overlap the active doping regions 600 in the third direction DR3. Both end portions of the gate electrode 155 may overlap the active doping regions 600 in the third direction DR3. For example, both end portions of the gate electrode 155 may overlap approximately the centers of the active doping regions 600 in the third direction DR3.

The positions of both end portions of the gate semiconductor layer 152 and the positions of both end portions of the gate electrode 155 are not limited those described above, and may be variously changed.

FIGS. 12 and 13 are cross-sectional views illustrating another example of a semiconductor device. FIG. 12 shows an alternate version of the cross-sectional view along line II-II' of FIG. 1 compared to FIG. 2. FIG. 13 shows an alternate version of the cross-sectional view along III-III' of FIG. 1 compared to FIG. 3.

Description relevant to FIGS. 1, 2, and 3 will not be repeated for FIGS. 12 and 13 for brevity. The same reference symbols are used for the elements identical to those described above. Compared to the semiconductor device of FIGS. 10 and 11, in that the gate semiconductor layer is omitted in the semiconductor device of FIGS. 12 and 13.

As shown in FIGS. 12 and 13, in the semiconductor device, no gate semiconductor layer may be positioned between the barrier layer 136 and the gate electrode 155. The gate electrode 155 may be positioned directly on the barrier layer 136. The lower surface of the gate electrode 155 may be in contact with the barrier layer 136.

The semiconductor device may be a normally-on high electron mobility transistor. In the normally-on high electron mobility transistor, in a state where no voltage is applied to the gate electrode 155, the 2-dimensional electron gas 134 may be used as a channel, and a flow of current may occur between the source electrode 173 and the drain electrode 175. Further, when a negative voltage is applied to the gate electrode 155, the depletion region DPR where the flow of the 2-dimensional electron gas 134 is cut off may occur under the gate electrode 155.

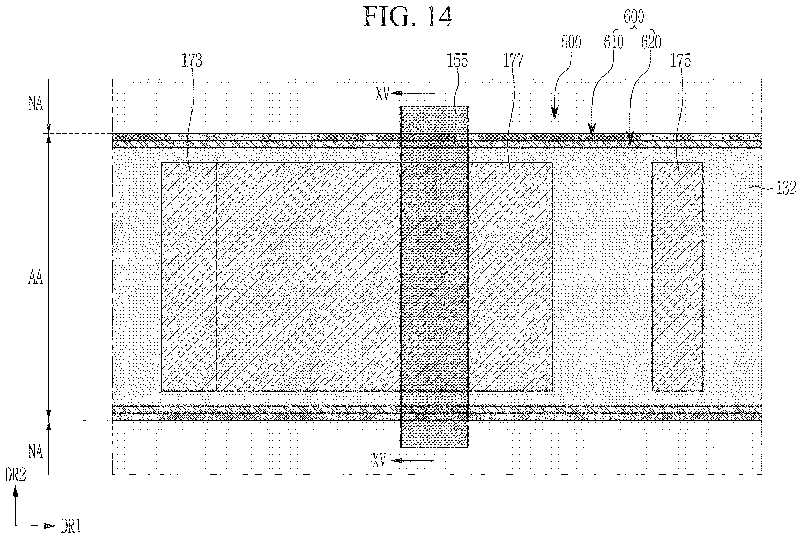

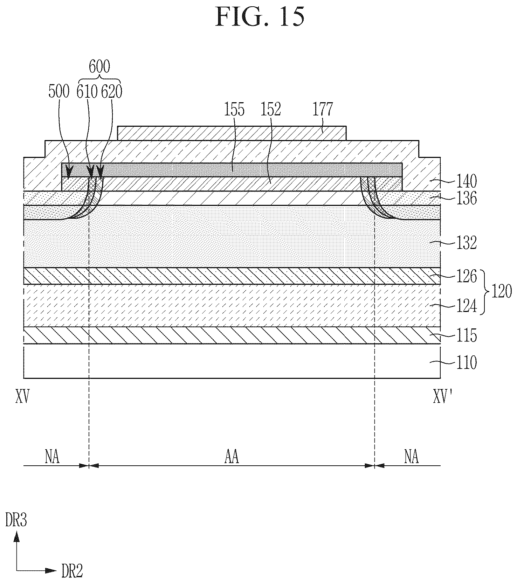

FIG. 14 is a plan view illustrating an example of a semiconductor, and FIG. 15 is a cross-sectional view taken along line XV-XV' of FIG. 14.

Description relevant to FIGS. 1, 2, and 3 will not be repeated for FIGS. 14 and 15 for brevity. The same reference symbols are used for the elements identical to those described above. In the semiconductor device of FIGS. 14 and 15, each active doping region 600 includes a plurality of regions.

As shown in FIGS. 14 and 15, the active doping regions 600 includes first active doping regions 610 and second active doping regions 620. The first active doping regions 610 may be positioned adjacent to the non-active doping regions 500 and be positioned adjacent to the second active doping regions 620. The first active doping regions 610 may be in contact with the non-active doping regions 500, and the second active doping regions 620 may be in contact with the first active doping regions 610. The first active doping regions 610 may be positioned between the non-active doping regions 500 and the second active doping regions 620.

The first active doping regions 610 may include a first active impurity, and the second active doping regions 620 may include a second active impurity. The first active doping regions 610 may further include the second active impurity. The first active impurity and the second active impurity may include a material such as fluorine (F), beryllium (Be), calcium (Ca), strontium (Sr), barium (Ba), lithium (Li), sodium (Na), manganese (Mn), iron (Fe), cobalt (Co), copper (Cu), zinc (Zn), cadmium (Cd), oxygen (O), magnesium (Mg), etc. The first active impurity and the second active impurity may consist of different materials. For example, the first active impurity may be fluorine (F), and the second active impurity may be oxygen (O). In this case, the first active doping regions 610 may include fluorine (F) and oxygen (O) together, and the second active doping regions 620 may include oxygen (O). However, the present disclosure is not limited thereto, and the first active doping regions 610 may include only fluorine (F), and the second active doping regions 620 may include only oxygen (O).

The width of the first active doping regions 610 in the second direction DR2 may be similar to the width of the second active doping regions 620 in the second direction DR2. For example, the width of the first active doping regions 610 in the second direction DR2 may be substantially the same as the width of the second active doping regions 620 in the second direction DR2. In some cases, the width of the first active doping regions 610 in the second direction DR2 may be different from the width of the second active doping regions 620 in the second direction DR2.

Although it has been described above that each active doping region 600 includes two regions, the present disclosure is not limited thereto. Each active doping region 600 may include three or more regions.

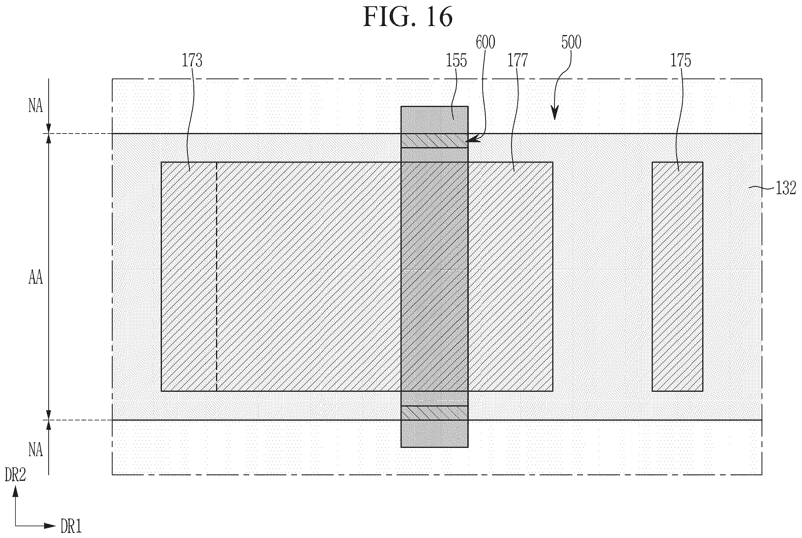

FIG. 16 is a plan view illustrating an example of a semiconductor device.

Description relevant to FIGS. 1, 2, and 3 will not be repeated for FIG. 16 for brevity. The same reference symbols are used for the elements identical to those described above. In the semiconductor device of FIG. 16, the active doping regions does not extend beyond the gate electrode 155, e.g., is not laterally displaced from either the source electrode 173 or the drain electrode 175 along the second direction DR2.

As shown in FIG. 16, in the semiconductor device, the active doping regions 600 is positioned in the active area AA adjacent to the non-active areas NA of the channel layer 132, and the non-active doping regions 500 are positioned in the non-active areas NA of the channel layer 132. The active doping regions 600 may extend in the first direction DR1 along the boundaries between the active area AA and the non-active areas NA. In the semiconductor device of FIGS. 1 to 15, the active doping regions 600 may extend along the entire boundaries between the active area AA and the non-active areas NA, and in the semiconductor device of FIG. 16, the active doping regions 600 may extend along some portions of the boundaries between the active area AA and the non-active areas NA. The active doping regions 600 may be positioned on both sides of the gate electrode 155. The active doping regions 600 may not be positioned on both sides of the source electrode 173 and the drain electrode 175. The active doping regions 600 may overlap the gate electrode 155 in the second direction DR2 and may not overlap the source electrode 173 and the drain electrode 175 in the second direction DR2. The active doping regions 600 may not overlap the portion of the channel layer 132 between the gate electrode 155 and the source electrode 173 in the second direction DR2 and may not overlap the portion of the channel layer 132 between the gate electrode 155 and the drain electrode 175 in the second direction DR2. In other words, the active doping regions 600 may be positioned only at portions adjacent to the gate electrode 155.

The length of each active doping region 600 in the first direction DR1 may be similar to the length of the gate electrode 155 in the first direction DR1. For example, the length of each active doping region 600 in the first direction DR1 may be substantially the same as the length of the gate electrode 155 in the first direction DR1. Alternatively, the length of each active doping region 600 in the first direction DR1 may be slightly longer than the length of the gate electrode 155 in the first direction DR1.

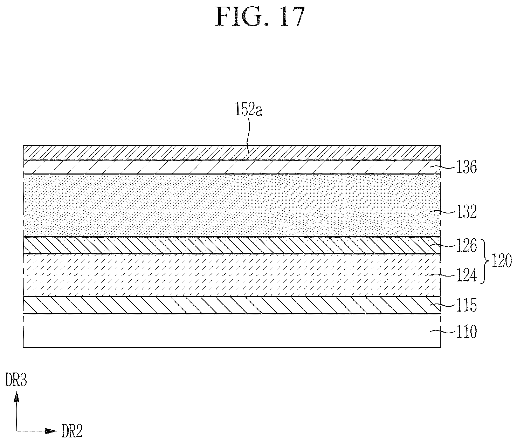

FIGS. 17 to 22 are cross-sectional views illustrating examples of methods of manufacturing semiconductor devices.

First, as shown in FIG. 17, on a substrate 110, a seed layer 115, a buffer layer 120, a channel layer 132, a barrier layer 136, and a gate semiconductor material layer 152a may be sequentially formed.

The substrate 110 may include a semiconductor material. For example, the substrate 110 may include sapphire, Si, SiC, AlN, GaN, or a combination thereof. The substrate 110 may be a silicon on insulator (SOI) substrate. However, the material of the substrate 110 is not limited thereto, and every substrate which is generally used may be applied.

The seed layer 115, the buffer layer 120, the channel layer 132, the barrier layer 136, and the gate semiconductor material layer 152a may be sequentially formed using an epitaxial growth method. On the substrate 110, the seed layer 115 may be first formed, and on the seed layer 115, the buffer layer 120 may be formed. The buffer layer 120 may include a superlattice layer 124 and a high-resistivity layer 126. On the buffer layer 120, the channel layer 132 may be formed, and on the channel layer 132, the barrier layer 136 may be formed, and on the barrier layer 136, the gate semiconductor material layer 152a may be formed.

The seed layer 115, the buffer layer 120, the channel layer 132, the barrier layer 136, and the gate semiconductor material layer 152a may consist of semiconductor materials based on the same materials. However, the material composition ratios of the individual layers may be different from one another in view of the roles of the individual layers, the performance required for the semiconductor device, and the like. The seed layer 115, the buffer layer 120, the channel layer 132, the barrier layer 136, and the gate semiconductor material layer 152a may include III-V materials, for example, one or more materials selected from nitrides including at least one material of Al, Ga, In, and B. The seed layer 115, the buffer layer 120, the channel layer 132, the barrier layer 136, and the gate semiconductor material layer 152a may be formed of AlₓIn_{y}Ga_{1-x-y}N (wherein 0≤x≤1, 0≤y≤1, and x+y≤1). For example, the seed layer 115, the buffer layer 120, the channel layer 132, the barrier layer 136, and the gate semiconductor material layer 152a may include at least one of AlN, GaN, InN, InGaN, AlGaN, AlInN, and AlInGaN. The barrier layer 136 may include a material having an energy band gap different from that of the channel layer 132. The barrier layer 136 may have an energy band gap higher than that of the channel layer 132. The gate semiconductor material layer 152a may include a material having an energy band gap different from that of the barrier layer 136.

As an example, the substrate 110 may include Si, and the seed layer 115 may include AlN, and the superlattice layer 124 may have a structure in which layers consisting of AlGaN and layers consisting of GaN are alternately stacked. The high-resistivity layer 126 may include GaN, and the channel layer 132 may include GaN, and the barrier layer 136 may include AlGaN. The channel layer 132 and the barrier layer 136 may be or may not be doped with an impurity. The gate semiconductor material layer 152a may include GaN and may be doped with an impurity. The gate semiconductor material layer 152a may be doped with a p-type impurity, for example, magnesium (Mg).

Since the lattice structure of Si and the lattice structure of GaN are different, growing the channel layer 132, consisting of GaN, directly on the substrate 110 consisting of Si can be difficult. In the disclosed method of manufacturing the semiconductor device, the seed layer 115, the buffer layer 120, and the like may be first formed on the substrate 110, and then the channel layer 132 may be formed, whereby the lattice structure of the channel layer 132 may be stably formed.

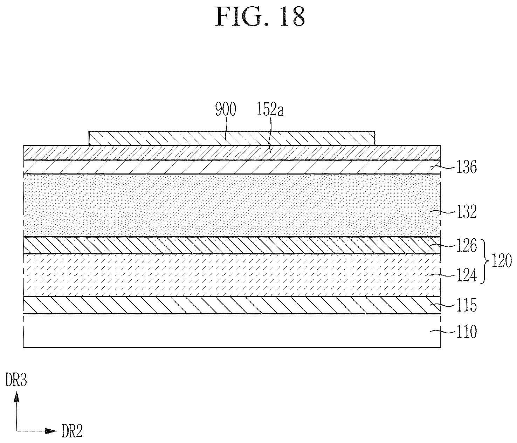

As shown in FIG. 18, on the gate semiconductor material layer 152a, a mask pattern 900 may be formed. The mask pattern 900 may be formed by forming a mask material layer on the gate semiconductor material layer 152a and then patterning the mask material layer. The mask pattern 900 may consist of a photoresist material and may be a hard mask consisting of a material such as SiO₂. The mask pattern 900 may consist of other materials.

The mask pattern 900 can cover some areas of the gate semiconductor material layer 152a. The mask pattern 900 covers portions of the gate semiconductor material layer 152a positioned below the mask pattern 900, and portions of the upper surface of the gate semiconductor material layer 152a not below the mask pattern 900 may be exposed to the outside.

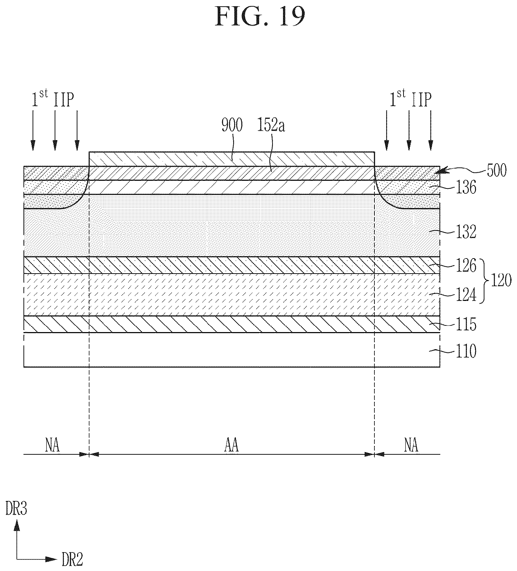

As shown in FIG. 19, a first ion implantation process (1^{st} IIP) may be performed using the mask pattern 900 as a mask to form the non-active doping regions 500.

In the first ion implantation process (1^{st} IIP), a non-active impurity may be implanted in a direction perpendicular to the substrate 110 or the channel layer 132. In other words, non-active doping regions 500 may be formed by implanting the non-active impurity in the third direction DR3. The non-active impurity may not be implanted into the portions covered by the mask pattern 900, and the non-active impurity may be implanted into the portions that are exposed and not covered by the mask pattern 900. The edges of the non-active doping regions 500 may be aligned with the edges of the mask pattern 900 in the third direction DR3. The non-active impurity may include a material such as Ar, H, etc. The non-active impurity may be implanted up to a predetermined depth. For example, the non-active impurity may be implanted into the gate semiconductor material layer 152a, the barrier layer 136, and the channel layer 132. The non-active doping regions 500 may be mostly distributed along the third direction DR3 from the upper surface to the lower surface of the gate semiconductor material layer 152a and be mostly distributed along the third direction DR3 from the upper surface to the lower surface of the barrier layer 136. The non-active doping regions 500 may be distributed only up to a predetermined depth from the upper surface of the channel layer 132. The depth of the non-active doping regions 500 may gradually increase with distance from the mask pattern 900 and then become constant.

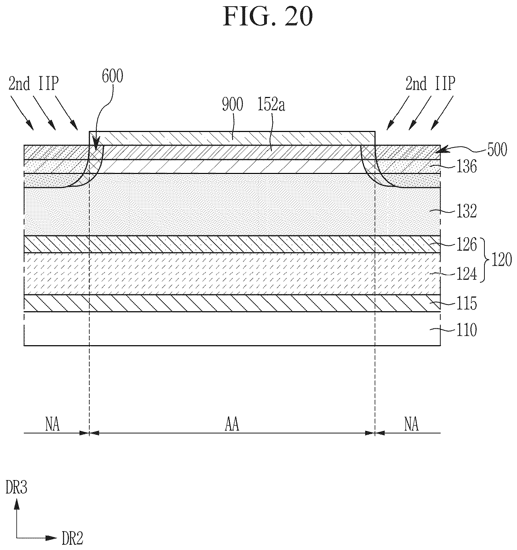

As shown in FIG. 20, a second ion implantation process (2^{nd} IIP) may be performed using the mask pattern 900 as a mask to form active doping regions 600.

In the second ion implantation process (2^{nd} IIP), an active impurity may be implanted in a direction oblique to the substrate 110 or the channel layer 132. In other words, the active impurity may be implanted so as to have a predetermined tilt angle with respect to the third direction DR3, to form the active doping regions 600. Even when the same mask pattern 900 is used to perform the first ion implantation process (1^{st} IIP) and the second ion implantation process (2^{nd} IIP), the regions into which the impurities are implanted in the individual processes may be different from each other. The active impurity may also be implanted into the non-active doping regions 500 and may also be implanted outside the non-active doping regions 500. The portions outside the non-active doping regions 500 into the active impurity are implanted may become the active doping regions 600. The active doping regions 600 may be in contact with the non-active doping regions 500. The active doping regions 600 may overlap the mask pattern 900 in the third direction DR3. The active doping regions 600 may overlap both edges of the mask pattern 900 in the third direction DR3.

The active impurity may include a material such as fluorine (F), beryllium (Be), calcium (Ca), strontium (Sr), barium (Ba), lithium (Li), sodium (Na), manganese (Mn), iron (Fe), cobalt (Co), copper (Cu), zinc (Zn), cadmium (Cd), oxygen (O), magnesium (Mg), etc. The active impurity may be implanted up to a predetermined depth. The implantation depth of the active impurity may be similar to or different from the implantation depth of the non-active impurity. For example, the implantation depth of the non-active impurity may be deeper than the implantation depth of the active impurity. For example, the active impurity may be implanted into the gate semiconductor material layer 152a, the barrier layer 136, and the channel layer 132. The active doping regions 600 may be mostly distributed along the third direction DR3 from the upper surface to the lower surface of the gate semiconductor material layer 152a and be mostly distributed along the third direction DR3 from the upper surface to the lower surface of the barrier layer 136. The active doping regions 600 may be distributed only up to a predetermined depth from the upper surface of the channel layer 132. The depth of the active doping regions 600 may gradually increase with distance from the mask pattern 900 and then become constant.

The second ion implantation process (2^{nd} IIP) may consist of a single process or may include a plurality of processes. For example, the second ion implantation process (2^{nd} IIP) may consist of a single process to implant one kind of impurity. In this case, the active doping regions 600 may include one kind of impurity. As another example, the second ion implantation process (2^{nd} IIP) may include two or more processes, and in the individual processes, different kinds of impurities may be implanted. In this case, the active doping regions 600 may include two or more kinds of impurities. In this case, the tilt angles in the individual processes constituting the second ion implantation process (2^{nd} IIP) may be different from each other. Accordingly, each active doping regions 600 may include a plurality of regions as in the semiconductor device of FIGS. 14 and 15.

Subsequently, the mask pattern 900 may be removed. A development process, an etching process, and the like may be used to remove the mask pattern 900.

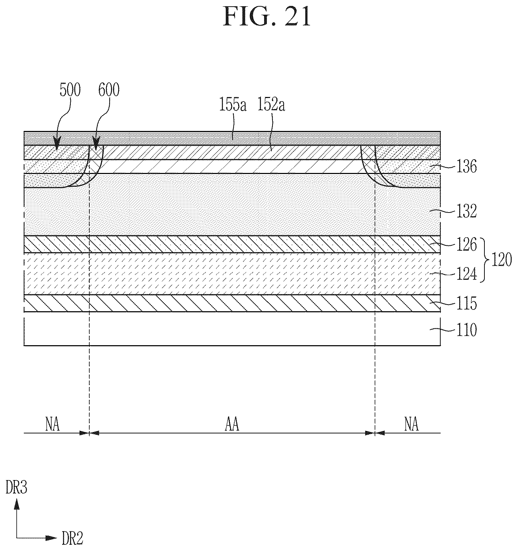

As shown in FIG. 21, a gate electrode material layer 155a may be formed on the gate semiconductor material layer 152a. The gate semiconductor material layer 152a is positioned between the barrier layer 136 and the gate electrode material layer 155a.

The gate electrode material layer 155a may be formed using a deposition process. For example, the gate electrode material layer 155a may be formed using at least one of e-beam evaporation, sputtering, physical vapor deposition (PVD), thermal chemical vapor deposition (thermal CVD), low-pressure chemical vapor deposition (LP-CVD), plasma-enhanced chemical vapor deposition (PE-CVD), and atomic layer deposition (ALD) techniques, but is not limited thereto.

The gate electrode material layer 155a may include a conductive material. For example, the gate electrode material layer 155a may include a metal, a metal alloy, a conductive metal nitride, a metal silicide, a doped semiconductor material, a conductive metal oxide, a conductive metal oxynitride, or the like. For example, the gate electrode material layer 155a may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate electrode material layer 155a may consist of a single layer or multiple layers.

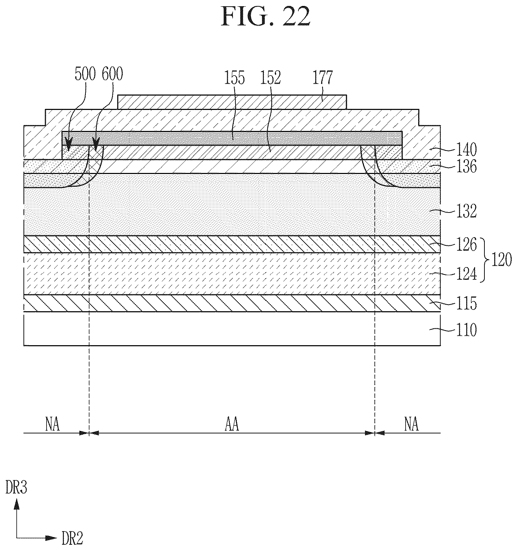

As shown in FIG. 22, the gate electrode 155 may be formed by patterning the gate electrode material layer 155a using an etching process. Subsequently, the gate semiconductor layer 152 may be formed by patterning the gate semiconductor material layer 152a using an etching process. The gate semiconductor layer 152 is positioned between the barrier layer 136 and the gate electrode 155. The gate electrode 155 may be brought into Schottky contact or ohmic contact with the gate semiconductor layer 152.

In the process of etching the gate semiconductor material layer 152a, in order to minimize damage to the barrier layer 136, a selective etching process condition to make a difference in the etch rate between the gate semiconductor material layer 152a and the barrier layer 136 is satisfied. For example, a condition may be determined such that while the barrier layer 136 consisting of AlGaN may be barely etched, the gate semiconductor material layer 152a consisting of p-GaN is well etched. In this case, oxygen (O₂) may be added to an etch gas and a surface oxidation etching method may be used. Accordingly, when the barrier layer 136 is not damaged and has a predetermined thickness, the channel layer 132 may have a high current density.

The gate semiconductor material layer 152a may be patterned using the gate electrode 155 or the hard mask pattern remaining on the gate electrode 155. Accordingly, the gate semiconductor layer 152 may have a pattern similar to the gate electrode 155. In other words, the gate semiconductor layer 152 and the gate electrode 155 may have substantially the same planar shape. However, the present disclosure is not limited thereto, and the gate electrode material layer 155a and the gate semiconductor material layer 152a may be patterned using different masks. In this case, the gate electrode 155 may have a planar shape different from that of the gate semiconductor layer 152. For example, like in the semiconductor device of FIGS. 10 and 11, a portion of the upper surface of the gate semiconductor layer 152 may be covered by the gate electrode 155, and the other portions may not be covered by the gate electrode 155.

Subsequently, on the barrier layer 136, the gate semiconductor layer 152, and the gate electrode 155, a protective layer 140 may be formed. The protective layer 140 may be formed using a deposition process. The protective layer 140 may include an insulating material. For example, the protective layer 140 may include a material such as SiO₂, SiN, SiON, Al₂O₃, etc. In the drawings, the protective layer 140 is shown as a single layer; however, in some cases, the protective layer may consist of multiple layers. In this case, the protective layer 140 may be formed by sequentially depositing different materials. Alternatively, a protective layer 140 that consists of multiple layers having different characteristics may be formed by depositing the same material under different deposition conditions. Particularly, portions of the protective layer 140 adjacent to the barrier layer 136 may consist of an insulating material having much higher quality than the other portions. This is for preventing electrons from forming a channel that is trapped in the channel layer 132 positioned below the barrier layer 136. The portions of the protective layer 140 in contact with the barrier layer 136 may consist of SiO₂.

Subsequently, the protective layer 140 may be patterned to form trenches, and in the trenches, a source electrode 173 and a drain electrode 175 may be formed. In this case, in the process of forming the trenches, the barrier layer 136 and the channel layer 132, as well as the protective layer 140, may be patterned together. Further, in the process of forming the source electrode 173 and the drain electrode 175, a field dispersion layer 177 may be formed together.

The source electrode 173 and the drain electrode 175 may be brought into ohmic contact with the channel layer 132. The regions in the channel layer 132 that are in contact with the source electrode 173 and the drain electrode 175 may be doped at a relatively higher concentration as compared to the other region. For example, the channel layer 132 may be doped by an ion implantation process, an annealing process, etc. However, the present disclosure is not limited thereto, and the process of doping the channel layer 132 may consist of various different processes. The process of doping the channel layer 132 may be performed before the source electrode 173 and the drain electrode 175 are formed. In some cases, the channel layer 132 may not be doped.

At the portion in the channel layer 132 adjacent to the barrier layer 136, the 2-dimensional electron gas 134 may be formed. The 2-dimensional electron gas 134 may be positioned at the interface between the channel layer 132 and the barrier layer 136. The 2-dimensional electron gas 134 may be positioned in the drift region DTR between the source electrode 173 and the drain electrode 175. By the gate semiconductor layer 152 having an energy band gap different from that of the barrier layer 136, a depletion region DPR may be formed in the channel layer 132. Accordingly, the semiconductor device may have a normally-off characteristic. In other words, the semiconductor device may be a normally-off high electron mobility transistor (HEMT). In the gate-off state, the 2-dimensional electron gas 134 may be positioned in the drift region DTR except for the depletion region DPR of the channel layer 132. In the gate-on state, the flow of the 2-dimensional electron gas 134 continues in the depletion region DPR, and thus the 2-dimensional electron gas 134 may be positioned throughout the the entire drift region DTR.

According to the disclosed methods of manufacturing the semiconductor device, since the active doping regions 600 are formed so as to be adjacent to the non-active areas NA of the channel layer 132 by doping the active area AA with a material such as fluorine (F), oxygen (O), magnesium (Mg), or the like, preventing leakage current from occurring in the portions of the channel layer 132 adjacent to both edges of the gate electrode 155 is possible. In other words, forming the active doping regions 600 at the edges of the active area AA in contact with the non-active areas NA of the channel layer 132, increases the threshold voltage of the high electron mobility transistor constituting the semiconductor device.

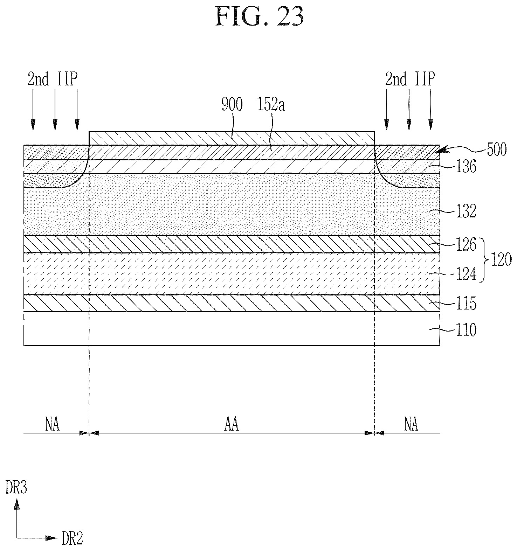

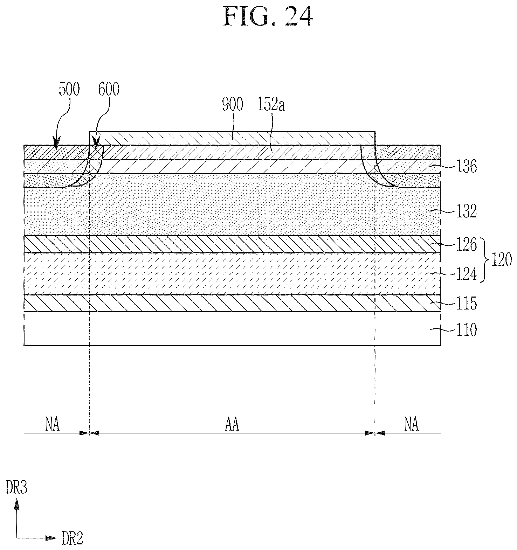

FIGS. 23 and 24 are cross-sectional views illustrating examples of a method of manufacturing semiconductor devices. In particular, the following steps described in relation to FIGS. 23 and 24 can follow after the stage represented in FIG. 19.

Since the example shown in FIGS. 23 and 24 has many processes identical to those in the embodiment shown in FIGS. 17 to 22, a description thereof will not be made and the differences will be mainly described. The same reference symbols are used for the elements identical to those described above . The example shown in FIGS. 23 and 24 may be partially different from the previous example in FIGS. 17-22 in that an annealing process is added.

As shown in FIGS. 17 to 19, on a substrate 110, a seed layer 115, a buffer layer 120, a channel layer 132, a barrier layer 136, and a gate semiconductor material layer 152a are sequentially formed, and on the gate semiconductor material layer 152a, a mask pattern 900 is formed. Thereafter, a first ion implantation process (1^{st} IIP) may be performed to form non-active doping regions 500.

As shown in FIG. 23, a second ion implantation process (2^{nd} IIP) may be performed using the mask pattern 900 as a mask.

In the second ion implantation process (2^{nd} IIP), an active impurity is implanted in a direction perpendicular to the substrate 110 or the channel layer 132, like in the first ion implantation process (1^{st} IIP). In other words, by implanting the active impurity in the third direction DR3, the active impurity is positioned in the non-active doping regions 500. The active impurity may not be implanted into the portions covered by the mask pattern 900, and the active impurity may be implanted into the portions that are exposed and not covered by the mask pattern 900. The active impurity may include a material such as fluorine (F), beryllium (Be), calcium (Ca), strontium (Sr), barium (Ba), lithium (Li), sodium (Na), manganese (Mn), iron (Fe), cobalt (Co), copper (Cu), zinc (Zn), cadmium (Cd), oxygen (O), magnesium (Mg), etc.

As shown in FIG. 24, active doping regions 600 may be formed by performing an annealing process.

The active impurity implanted in the second ion implantation process (2^{nd} IIP) may diffuse around the non-active doping regions 500. The non-active impurity implanted in the first ion implantation process (1^{st} IIP) is for amorphizing the lattice of the channel layer 132 by collisions between atoms to cut off the flow of the 2-dimensional electron gas 134 and may not diffuse around in the annealing process. The portions outside the non-active doping regions 500 to which the active impurity has diffused may become the active doping regions 600. The active doping regions 600 may be in contact with the non-active doping regions 500. The active doping regions 600 may overlap the mask pattern 900 in the third direction DR3. The active doping regions 600 may overlap both edges of the mask pattern 900 in the third direction DR3.

Subsequently, as described in relation to FIG. 20, after the mask pattern 900 is removed, the gate electrode 155, the protective layer 140, the source electrode 173, and the drain electrode 175 may be formed.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

It is to be understood that the invention is not limited to the present disclosure. It is intended to cover various modifications and equivalent arrangements included within the scope of the appended claims.

## Claims

1. A high-electron mobility transistor comprising:
a channel layer including a III-V material layer (132);
a barrier layer (136) on the channel layer (132), the barrier layer (136) including a III-V material having an energy band gap different from an energy band gap of the channel layer (132);
a gate electrode (155) on the barrier layer (136);
a source electrode (173) and a drain electrode (175) that are disposed on opposite sides of the gate electrode (155) in a first direction (DR1) and connected to the channel layer (132), the first direction (DR1) being perpendicular to a second direction (DR2) and a third direction (DR3), the third direction (DR3) being perpendicular to an upper surface of the channel layer (132); and
active impurity regions (600) spaced apart from each other in the second direction (DR2) and extending along the first direction (DR1), the active impurity regions (600) not overlapping the source electrode (173) and the drain electrode (175) in a plan view along the third direction (DR3), and
wherein, in a plan view along the third direction (DR3), the active impurity regions (600) overlap with end portions of the gate electrode (155) in the second direction (DR2), respectively, or, in a plan view along the third direction (DR3), the end portions of the gate electrode (155) in the second direction (DR2) are positioned together with edges of the active impurity regions (600) on same lines, respectively, and **characterized in that**
the active impurity regions (600) are included in the channel layer (132) and are regions doped with an active impurity, the active impurity including at least one of Be, Ca, Sr, Ba, Li, Na, Mn, Fe, Co, Cu, Zn, Cd, or Mg.

2. The high-electron mobility transistor of claim 1, wherein the channel layer (132) further comprises:
non-active impurity regions (500) spaced apart from each other in the second direction (DR2) and extending along the first direction (DR1), the non-active impurity regions (500) not overlapping the source electrode (173) and the drain electrode (175) in a plan view along the third direction (DR3), the non-active impurity regions (500) being regions doped with non-active impurity, the non-active impurity including at least one of Ar or H, and the non-active impurity regions (500) being in contact with the active impurity regions (600), respectively.

3. The high-electron mobility transistor of claim 2, wherein the non-active impurity region (500) further includes the active impurity, and
wherein the active impurity region (600) is free of the non-active impurity.

4. The high-electron mobility transistor of any one of claims 1 to 3, wherein a width of each one of the active impurity regions (600) in the second direction (DR2) is equal to or larger than 0.1 µm and equal to or smaller than 5 µm.

5. The high-electron mobility transistor of any one of claims 2 to 4, wherein, in a plan view along the third direction (DR3), the active impurity regions (600) overlap with end portions of the gate electrode (155) in the second direction (DR2), respectively, and wherein the gate electrode (155) overlaps the non-active impurity regions (500) in a plan view along the third direction (DR3).

6. The high-electron mobility transistor of any one of claims 1 to 5, further comprising a gate semiconductor layer (152) between the barrier layer (136) and the gate electrode (155),
wherein, in a plan view along the third direction (DR3), the active impurity regions (600) overlap with end portions of the gate electrode (155) in the second direction (DR2), respectively, and
wherein the gate semiconductor layer (152) overlaps the active impurity regions (600) in a plan view along the third direction (DR3).

7. The high-electron mobility transistor of claim 6, wherein the active impurity regions (600) extend into the barrier layer (136) and the gate semiconductor layer (152).

8. The high-electron mobility transistor of claim 6 or 7, wherein the gate semiconductor layer (152) overlaps the non-active impurity regions (500) in a plan view along the third direction (DR3), and
wherein the non-active impurity regions (500) extend into the barrier layer (136) and the gate semiconductor layer (152).

9. The high-electron mobility transistor of any one of claims 1 to 8,
wherein, in a plan view along the third direction (DR3), the active impurity regions (600) overlap with end portions of the gate electrode (155) in the second direction (DR2), respectively, and
wherein lengths of each of the active impurity regions (600) in the first direction (DR1) is the same as a length of the gate electrode (155) in the first direction (DR1).

10. The high-electron mobility transistor of any one of claims 1 to 9, wherein the active impurity regions (600) include two or more kinds of the active impurities.

11. The high-electron mobility transistor of any one of claims 2 to 10,
wherein, in a plan view along the third direction (DR3), the active impurity regions (600) overlap with end portions of the gate electrode (155) in the second direction (DR2), respectively, and
wherein each of the active impurity regions (600) includes:
a first active impurity region (610) in contact with the corresponding non-active impurity region (500); and
a second active impurity region (620) in contact with the first active impurity region (610); and
the first active impurity region (610) is positioned between the corresponding non-active impurity region (500) and the second active impurity region (620).

## Patentansprüche

1. Transistor mit hoher Elektronenmobilität, umfassend:
eine Kanalschicht, die eine III-V-Materialschicht (132) enthält;
eine Barrierenschicht (136) auf der Kanalschicht (132), wobei die Barrierenschicht (136) ein III-V-Material enthält, das eine von einer Energiebandlücke der Kanalschicht (132) verschiedene Energiebandlücke aufweist;
eine Gate-Elektrode (155) auf der Barrierenschicht (136);
eine Source-Elektrode (173) und eine Drain-Elektrode (175), die auf gegenüberliegenden Seiten der Gate-Elektrode (155) in einer ersten Richtung (DR1) angeordnet und mit der Kanalschicht (132) verbunden sind, wobei die erste Richtung (DR1) senkrecht zu einer zweiten Richtung (DR2) und einer dritten Richtung (DR3) ist und die dritte Richtung (DR3) senkrecht zu einer oberen Oberfläche der Kanalschicht (132) ist; und
aktive Störstellenbereiche (600), die in der zweiten Richtung (DR2) voneinander beabstandet sind und sich entlang der ersten Richtung (DR1) erstrecken, wobei die aktiven Störstellenbereiche (600) in einer Draufsicht entlang der dritten Richtung (DR3) die Source-Elektrode (173) und die Drain-Elektrode (175) nicht überlappen, und
wobei die aktiven Störstellenbereiche (600) in einer Draufsicht entlang der dritten Richtung (DR3) jeweils mit Endabschnitten der Gate-Elektrode (155) in der zweiten Richtung (DR2) überlappen oder die Endabschnitte der Gate-Elektrode (155) in der zweiten Richtung (DR2) in einer Draufsicht entlang der dritten Richtung (DR3) jeweils auf denselben Linien wie Kanten der aktiven Störstellenbereiche (600) liegen, und **dadurch gekennzeichnet, dass**
die aktiven Störstellenbereiche (600) in der Kanalschicht (132) enthalten und mit einer aktiven Störstelle dotierte Bereiche sind, wobei die aktive Störstelle mindestens eines der Elemente Be, Ca, Sr, Ba, Li, Na, Mn, Fe, Co, Cu, Zn, Cd und Mg umfasst.

2. Transistor mit hoher Elektronenmobilität nach Anspruch 1, wobei die Kanalschicht (132) ferner umfasst:
nichtaktive Störstellenbereiche (500), die in der zweiten Richtung (DR2) voneinander beabstandet sind und sich entlang der ersten Richtung (DR1) erstrecken, wobei die nichtaktiven Störstellenbereiche (500) in einer Draufsicht entlang der dritten Richtung (DR3) die Source-Elektrode (173) und die Drain-Elektrode (175) nicht überlappen, die nichtaktiven Störstellenbereiche (500) mit einer nichtaktiven Störstelle dotierte Bereiche sind, die nichtaktive Störstelle mindestens eines von Ar und H umfasst und die nichtaktiven Störstellenbereiche (500) jeweils mit den aktiven Störstellenbereichen (600) in Kontakt stehen.

3. Transistor mit hoher Elektronenmobilität nach Anspruch 2, wobei der nichtaktive Störstellenbereich (500) ferner die aktive Störstelle enthält, und
wobei der aktive Störstellenbereich (600) frei von der nichtaktiven Störstelle ist.

4. Transistor mit hoher Elektronenmobilität nach einem der Ansprüche 1 bis 3, wobei eine Breite jedes der aktiven Störstellenbereiche (600) in der zweiten Richtung (DR2) größer oder gleich 0,1 µm und kleiner oder gleich 5 µm ist.

5. Transistor mit hoher Elektronenmobilität nach einem der Ansprüche 2 bis 4, wobei die aktiven Störstellenbereiche (600) in einer Draufsicht entlang der dritten Richtung (DR3) jeweils mit Endabschnitten der Gate-Elektrode (155) in der zweiten Richtung (DR2) überlappen und wobei die Gate-Elektrode (155) in einer Draufsicht entlang der dritten Richtung (DR3) die nichtaktiven Störstellenbereiche (500) überlappt.

6. Transistor mit hoher Elektronenmobilität nach einem der Ansprüche 1 bis 5, ferner umfassend eine Gate-Halbleiterschicht (152) zwischen der Barrierenschicht (136) und der Gate-Elektrode (155),
wobei die aktiven Störstellenbereiche (600) in einer Draufsicht entlang der dritten Richtung (DR3) jeweils mit Endabschnitten der Gate-Elektrode (155) in der zweiten Richtung (DR2) überlappen, und
wobei die Gate-Halbleiterschicht (152) in einer Draufsicht entlang der dritten Richtung (DR3) die aktiven Störstellenbereiche (600) überlappt.

7. Transistor mit hoher Elektronenmobilität nach Anspruch 6, wobei sich die aktiven Störstellenbereiche (600) in die Barrierenschicht (136) und die Gate-Halbleiterschicht (152) hinein erstrecken.

8. Transistor mit hoher Elektronenmobilität nach Anspruch 6 oder 7, wobei die Gate-Halbleiterschicht (152) in einer Draufsicht entlang der dritten Richtung (DR3) die nichtaktiven Störstellenbereiche (500) überlappt, und
wobei sich die nichtaktiven Störstellenbereiche (500) in die Barrierenschicht (136) und die Gate-Halbleiterschicht (152) hinein erstrecken.

9. Transistor mit hoher Elektronenmobilität nach einem der Ansprüche 1 bis 8,
wobei die aktiven Störstellenbereiche (600) in einer Draufsicht entlang der dritten Richtung (DR3) jeweils mit Endabschnitten der Gate-Elektrode (155) in der zweiten Richtung (DR2) überlappen, und
wobei eine Länge jedes der aktiven Störstellenbereiche (600) in der ersten Richtung (DR1) gleich einer Länge der Gate-Elektrode (155) in der ersten Richtung (DR1) ist.

10. Transistor mit hoher Elektronenmobilität nach einem der Ansprüche 1 bis 9, wobei die aktiven Störstellenbereiche (600) zwei oder mehr Arten aktiver Störstellen enthalten.

11. Transistor mit hoher Elektronenmobilität nach einem der Ansprüche 2 bis 10,
wobei die aktiven Störstellenbereiche (600) in einer Draufsicht entlang der dritten Richtung (DR3) jeweils mit Endabschnitten der Gate-Elektrode (155) in der zweiten Richtung (DR2) überlappen, und
wobei jeder der aktiven Störstellenbereiche (600) umfasst:
einen ersten aktiven Störstellenbereich (610), der mit dem entsprechenden nichtaktiven Störstellenbereich (500) in Kontakt steht; und
einen zweiten aktiven Störstellenbereich (620), der mit dem ersten aktiven Störstellenbereich (610) in Kontakt steht; und
der erste aktive Störstellenbereich (610) zwischen dem entsprechenden nichtaktiven Störstellenbereich (500) und dem zweiten aktiven Störstellenbereich (620) angeordnet ist.

## Revendications

1. Transistor à haute mobilité électronique comprenant :
une couche de canal comprenant une couche de matériau III-V (132) ;
une couche barrière (136) sur la couche de canal (132), la couche barrière (136) comprenant un matériau III-V ayant une largeur de bande interdite différente d'une largeur de bande interdite de la couche de canal (132) ;
une électrode de grille (155) sur la couche barrière (136) ;
une électrode de source (173) et une électrode de drain (175) qui sont disposées disposées sur des côtés opposés de l'électrode de grille (155) selon une première direction (DR1) et reliées à la couche de canal (132), la première direction (DR1) étant perpendiculaire à une deuxième direction (DR2) et à une troisième direction (DR3), la troisième direction (DR3) étant perpendiculaire à une surface supérieure de la couche de canal (132) ; et
des régions d'impureté active (600) espacées les unes des autres dans la deuxième direction (DR2) et s'étendant le long de la première direction (DR1), les régions d'impureté active (600) ne chevauchant pas l'électrode de source (173) et l'électrode de drain (175) dans une vue en plan suivant la troisième direction (DR3), et
dans lequel, dans une vue en plan suivant la troisième direction (DR3), les régions d'impureté active (600) chevauchent respectivement des portions d'extrémité de l'électrode de grille (155) dans la deuxième direction (DR2), ou, dans une vue en plan suivant la troisième direction (DR3), les portions d'extrémité de l'électrode de grille (155) dans la deuxième direction (DR2) sont respectivement situées sur les mêmes lignes que des bords des régions d'impureté active (600), et **caractérisé en ce que**
les régions d'impureté active (600) sont comprises dans la couche de canal (132) et sont des régions dopées avec une impureté active, l'impureté active comprenant au moins l'un des éléments Be, Ca, Sr, Ba, Li, Na, Mn, Fe, Co, Cu, Zn, Cd et Mg.

2. Transistor à haute mobilité électronique selon la revendication 1, dans lequel la couche de canal (132) comprend en outre :
des régions d'impureté non active (500) espacées les unes des autres dans la deuxième direction (DR2) et s'étendant le long de la première direction (DR1), les régions d'impureté non active (500) ne chevauchant pas l'électrode de source (173) et l'électrode de drain (175) dans une vue en plan suivant la troisième direction (DR3), les régions d'impureté non active (500) étant des régions dopées avec une impureté non active, l'impureté non active comprenant au moins l'un de Ar et H, et les régions d'impureté non active (500) étant respectivement en contact avec les régions d'impureté active (600).

3. Transistor à haute mobilité électronique selon la revendication 2, dans lequel la région d'impureté non active (500) comprend en outre l'impureté active, et
dans lequel la région d'impureté active (600) est exempte de l'impureté non active.

4. Transistor à haute mobilité électronique selon l'une quelconque des revendications 1 à 3, dans lequel une largeur de chacune des régions d'impureté active (600) dans la deuxième direction (DR2) est supérieure ou égale à 0,1 µm et inférieure ou égale à 5 µm.

5. Transistor à haute mobilité électronique selon l'une quelconque des revendications 2 à 4, dans lequel, dans une vue en plan suivant la troisième direction (DR3), les régions d'impureté active (600) chevauchent respectivement des portions d'extrémité de l'électrode de grille (155) dans la deuxième direction (DR2), et dans lequel l'électrode de grille (155) chevauche les régions d'impureté non active (500) dans une vue en plan suivant la troisième direction (DR3).

6. Transistor à haute mobilité électronique selon l'une quelconque des revendications 1 à 5, comprenant en outre une couche semi-conductrice de grille (152) entre la couche barrière (136) et l'électrode de grille (155),
dans lequel, dans une vue en plan suivant la troisième direction (DR3), les régions d'impureté active (600) chevauchent respectivement des portions d'extrémité de l'électrode de grille (155) dans la deuxième direction (DR2), et
dans lequel la couche semi-conductrice de grille (152) chevauche les régions d'impureté active (600) dans une vue en plan suivant la troisième direction (DR3).

7. Transistor à haute mobilité électronique selon la revendication 6, dans lequel les régions d'impureté active (600) s'étendent dans la couche barrière (136) et la couche semi-conductrice de grille (152).

8. Transistor à haute mobilité électronique selon la revendication 6 ou 7, dans lequel la couche semi-conductrice de grille (152) chevauche les régions d'impureté non active (500) dans une vue en plan suivant la troisième direction (DR3), et
dans lequel les régions d'impureté non active (500) s'étendent dans la couche barrière (136) et la couche semi-conductrice de grille (152).

9. Transistor à haute mobilité électronique selon l'une quelconque des revendications 1 à 8,
dans lequel, dans une vue en plan suivant la troisième direction (DR3), les régions d'impureté active (600) chevauchent respectivement des portions d'extrémité de l'électrode de grille (155) dans la deuxième direction (DR2), et
dans lequel la longueur de chacune des régions d'impureté active (600) dans la première direction (DR1) est égale à une longueur de l'électrode de grille (155) dans la première direction (DR1).

10. Transistor à haute mobilité électronique selon l'une quelconque des revendications 1 à 9, dans lequel les régions d'impureté active (600) comprennent au moins deux types d'impuretés actives.

11. Transistor à haute mobilité électronique selon l'une quelconque des revendications 2 à 10,
dans lequel, dans une vue en plan suivant la troisième direction (DR3), les régions d'impureté active (600) chevauchent respectivement des portions d'extrémité de l'électrode de grille (155) dans la deuxième direction (DR2), et
dans lequel chacune des régions d'impureté active (600) comprend :
une première région d'impureté active (610) en contact avec la région d'impureté non active (500) correspondante ; et
une deuxième région d'impureté active (620) en contact avec la première région d'impureté active (610) ; et
la première région d'impureté active (610) est positionnée entre la région d'impureté non active (500) correspondante et la deuxième région d'impureté active (620).
